# EUROPEAN PATENT APPLICATION

(11) **EP 4 629 763 A1**
(43) Date of publication of application: **08.10.2025**
(21) Application number: 23898066.8
(22) Date of filing: 16.10.2023
(51) Int. Cl.: H05K 7/20, H04W 4/40, H04W 4/02, H04W 88/06, H04B 1/036, H04B 1/3822

(54) **ELECTRONIC DEVICE MOUNTED ON VEHICLE AND OPERATING METHOD THEREOF**

(30) Priority: 02.12.2022 KR 20220167035
(71) Applicant: Samsung Electronics Co., Ltd., Suwon-si, Gyeonggi-do 16677 (KR)
(72) Inventor: LEE, Dayoung, Suwon-si, Gyeonggi-do 16677 (KR); KIM, Hyunggon, Suwon-si, Gyeonggi-do 16677 (KR); BAEK, Houn, Suwon-si, Gyeonggi-do 16677 (KR)
(74) Representative: Gulde & Partner
(86) International application number: PCT/KR2023/015944
(87) International publication number: WO 2024/117532

(57) **Abstract**

Disclosed are an electronic device for cooling internal components of a vehicle and an operating method of the electronic device. An embodiment of the present disclosure provides an electronic device capable of determining a cooling level for lowering the temperature of a communication module to a target temperature, based on an outside air temperature around a vehicle and operating state information about the communication module, and performing adaptive dynamic cooling of the communication module by applying a variable voltage to an active cooler based on the determined cooling level.

## Description

### Technical Field

The present disclosure relates to an electronic device mounted on a vehicle and an operating method thereof. More particularly, the present disclosure relates to an electronic device for controlling a temperature of a communication module mounted on a vehicle and an operating method of the electronic device.

### Background Art

Recently, Vehicle-to-Everything (V2X) communication for transmitting and receiving data via a wireless communication network centered around vehicles has come into use. Furthermore, communication modules capable of high-frequency communication, such as millimeter-wave (mmWave) communication, have been mounted on vehicles. By applying communication technologies, such as V2X communication or millimeter-wave communication, to vehicles, technologies enabling enhancements in driver safety and autonomous driving have been developed and distributed.

A V2X communication module or a millimeter-wave communication module is arranged on an exterior structure of a vehicle in order to minimize radio-frequency (RF) loss by maintaining a minimal distance to a base station antenna. Because the V2X communication module or millimeter-wave communication module is arranged on the exterior structure of the vehicle, in a case that the outside air temperature is high, the temperature of components in the communication module, such as integrated circuits (ICs), increases, which may lower operational stability, including operational stoppage or performance degradation. In particular, during summer in a case that the outside air temperature is high, the internal temperature of the vehicle rises to 100 °C or higher, and in a case that the communication module consumes power under these conditions, internal components therein may undergo a temperature increase to 100 °C or higher, leading to thermal issues. The maximum operating temperature for most communication modules is 105 °C, and in particular, communication modules using high frequencies, such as millimeter-wave communication modules, stop operating when their temperature exceeds 80 °C. Furthermore, temperature control of a communication module is essential to prevent issues regarding increased leakage current and reduced lifespan of integrated circuits due to the temperature of semiconductors constituting the communication module.

For integrated circuits that generate significant heat due to high power consumption, such as V2X communication modules, millimeter-wave communication modules, or application processors (APs) that use high frequencies, a method of attaching a heat dissipation part (e.g., a heat sink) to disperse the generated heat into the surroundings or performing rapid cooling by using a cooler may be employed to counter temperature increases above a certain threshold. However, performing uninterrupted cooling by using a cooler also leads to high power consumption, whereas, when uninterrupted cooling is not performed, the communication module requires time to cool down, potentially rendering the communication module inoperable when needed (e.g., for data transmission and reception with a base station).

### Disclosure of Invention

### Solution to Problem

The present disclosure provides an electronic device mounted on a vehicle. The electronic device according to an aspect of the present disclosure may include a sensing unit including a temperature sensor, a communication module including at least one of a millimeter-wave communication module and a vehicle-to-everything (V2X) communication module, an active cooler including a thermoelectric cooler (TEC) and a fan, and configured to lower a temperature of the communication module according to applied power, a voltage regulator configured to adjust operating power applied to the active cooler, a memory storing at least one instruction, and at least one processor configured to execute the at least one instruction. The at least one processor may obtain an outside air temperature around the vehicle, which is measured by the temperature sensor. The at least one processor may obtain operating state information about the communication module, the operating state information including information about at least one of a power consumption and a temperature of the communication module. The at least one processor may determine, based on the outside air temperature of the vehicle and the operating state information about the communication module, a cooling level for lowering the temperature of the communication module to a target temperature. The at least one processor may control the voltage regulator to apply a variable voltage to the active cooler based on the determined cooling level.

The present disclosure provides an operation method of an electronic device mounted on a vehicle. The operating method of the electronic device according to an aspect of the present disclosure may include obtaining an outside air temperature of the vehicle measured by a temperature sensor. In an embodiment of the present disclosure, the operating method of the electronic device may include obtaining operating state information about a communication module, the operating state information including information about at least one of a power consumption and a temperature of at least one of a millimeter-wave (mmWave) communication module and a V2X communication module. In an embodiment of the present disclosure, the operating method of the electronic device may include determining, based on the outside air temperature and the operating state information about the communication module, a cooling level for lowering a temperature of the communication module to a target temperature. In an embodiment of the present disclosure, the operating method of the electronic device may include applying, based on the determined cooling level, a variable voltage to an active cooler.

The present disclosure provides a computer program product including a computer-readable storage medium. The storage medium according to an aspect of the present disclosure may include instructions readable by an electronic device, the instructions causing the electronic device to perform obtaining an outside air temperature of a vehicle measured by a temperature sensor, obtaining operating state information about a communication module, the operating state information including information about at least one of a power consumption and a temperature of at least one of a millimeter-wave (mmWave) communication module and a V2X communication module, determining, based on the outside air temperature and the operating state information about the communication module, a cooling level for lowering a temperature of the communication module to a target temperature, and applying, based on the determined cooling level, a variable voltage to an active cooler.

### Brief Description of Drawings

The present disclosure may be readily understood with a combination of the following detailed descriptions and the accompanying drawings, wherein reference numbers refer to structural elements.
FIG. 1A is a perspective view illustrating an exterior of an electronic device according to an embodiment of the present disclosure.
FIG. 1B is a rear view illustrating an exterior of an electronic device according to an embodiment of the present disclosure.
FIG. 2 is a block diagram illustrating components of an electronic device according to an embodiment of the present disclosure.
FIG. 3 is a diagram illustrating operations of components of an electronic device and data transmitted and received between the components, according to an embodiment of the present disclosure.
FIG. 4 is a flowchart of an operating method of an electronic device according to an embodiment of the present disclosure.
FIG. 5 illustrates graphs for describing an operation, performed by an electronic device, of determining a cooling level and applying a variable voltage to an active cooler, according to an embodiment of the present disclosure.
FIG. 6 is a flowchart of a method, performed by an electronic device, of adjusting a cooling level based on an event associated with a communication module, according to an embodiment of the present disclosure.
FIG. 7 is a flowchart of a method, performed by an electronic device, of adjusting a cooling level based on a driving speed of a vehicle, according to an embodiment of the present disclosure.
FIG. 8 is a diagram illustrating an operation, performed by an electronic device, of performing precooling based on a current position of a vehicle, according to an embodiment of the present disclosure.
FIG. 9 is a graph for describing an operation, performed by an electronic device, of performing precooling of a communication module, according to an embodiment of the present disclosure.
FIG. 10 is a diagram illustrating a look-up table (LUT) of voltage setting values of a variable voltage to be applied according to cooling temperature values for a communication module, according to an embodiment of the present disclosure.
FIG. 11 is a flowchart of a method, performed by an electronic device, of selecting an LUT based on an outside air temperature around the vehicle, obtain a voltage setting value by loading the selected LUT, and applying the obtained voltage setting value to an active cooler, according to an embodiment of the present disclosure.
FIG. 12A is a diagram illustrating an example of an LUT including information about voltage setting values corresponding to cooling temperature values for a communication module, for a particular outside air temperature.
FIG. 12B is a diagram illustrating an example of an LUT including information about voltage setting values corresponding to cooling temperature values for a communication module, for a particular outside air temperature.
FIG. 13 is a diagram for describing an operation, performed by an electronic device, of calibrating voltage setting values of an LUT, according to an embodiment of the present disclosure.
FIG. 14 is a diagram for describing an operation performed by an electronic device using artificial intelligence technology, according to the present disclosure.
FIG. 15 is a diagram illustrating an embodiment in which an electronic device operates in conjunction with a server, according to the present disclosure.
FIG. 16 is a diagram for describing FIG. 15 in detail.

### Mode for the Invention

Although the terms used herein for describing embodiments of the present specification are selected from among common terms that are currently widely used in consideration of their function in the present disclosure, the terms may be different according to an intention of those of ordinary skill in the art, a precedent, or the advent of new technology. Also, in particular cases, the terms are discretionally selected by the applicant of the present disclosure, in which case, the meaning of those terms will be described in detail in the corresponding embodiment. Therefore, the terms used herein are not merely designations of the terms, but the terms are defined based on the meaning of the terms and content throughout the present disclosure.

The singular expression may also include the plural meaning as long as it is not inconsistent with the context. All the terms used herein, including technical and scientific terms, may have the same meanings as those generally understood by those of skill in the art related to the present specification.

Throughout the present disclosure, when a part "includes" an element, it is to be understood that the part may additionally include other elements rather than excluding other elements as long as there is no particular opposing recitation. In addition, as used herein, the terms such as "...er (or)", "... unit", "... module", etc., denote a unit that performs at least one function or operation, which may be implemented as hardware or software or a combination thereof.

As used herein, the expression "configured to" may be interchangeably used with, for example, "suitable for", "having the capacity to", "designed to", "adapted to", "made to", or "capable of", according to a situation. The expression "configured to" may not imply only "specially designed to" in a hardware manner. Instead, in a certain circumstance, the expression "a system configured to" may indicate the system "capable of" together with another device or components. For example, "a processor configured (or set) to perform A, B, and C" may imply a dedicated processor (e.g., an embedded processor) for performing a corresponding operation or a generic-purpose processor (e.g., central processing unit (CPU) or an application processor) capable of performing corresponding operations by executing one or more software programs stored in a memory.

In addition, in the present disclosure, it should be understood that when components are "connected" or "coupled" to each other, the elements may be directly connected or coupled to each other, but may alternatively be connected or coupled to each other with an element therebetween, unless specified otherwise.

In the present disclosure, a 'vehicle' refers to a means of transport that travels on roads or tracks. The term 'vehicle' may encompass internal-combustion-engine vehicles equipped with an engine as a power source, hybrid vehicles equipped with an engine and an electric motor as power sources, and electric vehicles equipped with an electric motor as a power source. In an embodiment of the present disclosure, a vehicle may include at least one of an automobile, a train, and a motorcycle.

In the present disclosure, 'vehicle-to-everything (V2X) communication' refers to technology enabling a vehicle to transmit and receive data to and from other vehicles and objects connected to infrastructure such as roads, via wired or wireless communication networks, and encompasses Vehicle-to-Vehicle (V2V), Vehicle-to-Infrastructure (V2I), Vehicle-to-Pedestrian (V2P), and Vehicle-to-Network (V2N) communications.

In the present disclosure, a 'communication module' refers to a hardware device configured to connect to a wired or wireless communication network to perform data transmission and reception. A communication module of the present disclosure may be mounted on a vehicle. In an embodiment of the present disclosure, the communication module may include, but is not limited to, a V2X communication module and a millimeter-wave (mmWave) communication module.

In the present disclosure, an 'active cooler' refers to a cooler configured to dynamically apply cooling performance according to power applied thereto. In an embodiment of the present disclosure, the active cooler may adjust cooling performance according to the voltage value of an applied variable voltage.

In the present disclosure, a 'cooling level' represents cooling performance associated with cooling a cooling target by a particular cooling temperature value. In an embodiment of the present disclosure, a cooling level may be determined in proportion to a temperature difference between the current temperature of a cooling target and a target temperature, i.e., a cooling temperature value.

Hereinafter, embodiments of the present disclosure will be described in detail with reference to the accompanying drawings to allow those of skill in the art to easily carry out the embodiments. The present disclosure may, however, be embodied in many different forms and should not be construed as being limited to an embodiment set forth herein.

Hereinafter, embodiments of the disclosure will be described in detail with reference to the drawings.

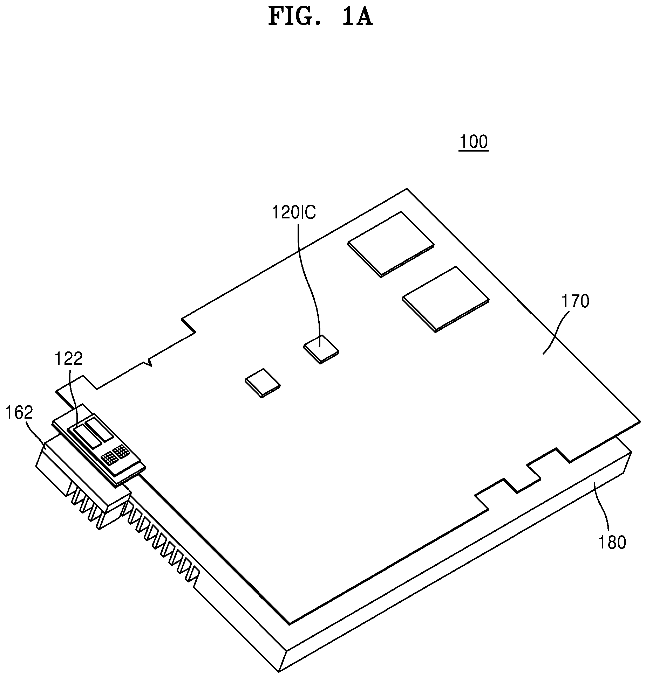

FIG. 1A is a perspective view illustrating an exterior of an electronic device 100 according to an embodiment of the present disclosure.

The electronic device 100 may be mounted on an exterior structure of a vehicle or arranged inside the exterior structure. In an embodiment of the present disclosure, the electronic device 100 may be arranged on each metal structure forming a roof of the vehicle.

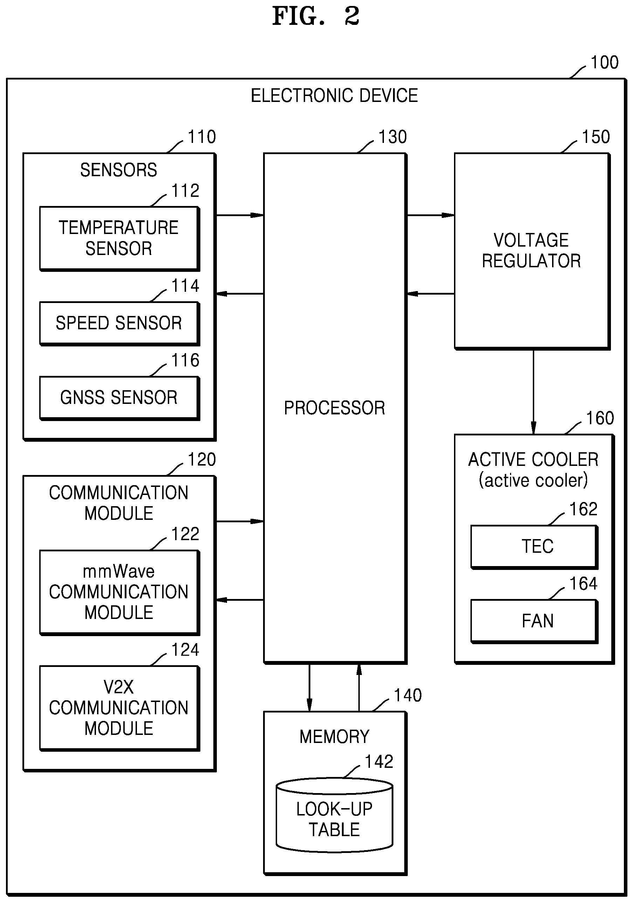

Referring to FIG. 1A, the electronic device 100 may include an integrated circuit 120IC constituting a communication module 120 (see FIG. 2), a millimeter-wave communication module 122, a thermoelectric cooler (TEC) 162, a circuit board 170, and a heat sink 180. FIG. 1A illustrates only components included in the exterior of the electronic device 100, and the components included in the electronic device 100 are not limited to those illustrated in FIG. 1A.

The integrated circuit 120IC is a semiconductor chip integrating, in a single package, components included in the communication module 120, such as a dedicated short-range communications (DSRC) modem, a Wi-Fi module, a mobile communication module (e.g., a Long-Term Evolution (LTE), 5G, or 5G New Radio (NR) module), or an application processor (AP). In an embodiment of the present disclosure, the integrated circuit 120IC may be included in at least one of a V2X communication module 124 (see FIG. 2) and the millimeter-wave communication module 122.

The millimeter-wave communication module 122 is a communication device configured to perform data communication in the frequency band between 30 GHz and 300 GHz. The millimeter-wave communication module 122 may include at least one antenna array and may transmit and receive data via a communication channel established with a base station, by using the at least one antenna array.

The integrated circuit 120IC and the millimeter-wave communication module 122 may be mounted on the circuit board 170. Although not illustrated in the drawings, the circuit board 170 may have mounted thereon sensors 110 (see FIG. 2) configured to sense information about an external environment (e.g., an outside air temperature, a vehicle driving speed, or a current vehicle position), at least one processor 130 (see FIG. 2) configured to perform computation and control of various components, and a memory 140 (see FIG. 2) configured to store data values.

The TEC 162 is a cooler including a Peltier element in which, when power is applied, heat is generated on one side while the other side cools as heat is dissipated from it. In an embodiment of the present disclosure, cooling performance may be determined by the magnitude of a voltage applied to the TEC 162. In the embodiment illustrated in FIG. 1A, the TEC 162 may be arranged in contact with the lower surface of the millimeter-wave communication module 122, and may cool the millimeter-wave communication module 122. The TEC 162 may be arranged in contact with the upper surface of the heat sink 180.

The heat sink 180 is a structure configured to absorb heat from a heat-generating body via direct or indirect thermal contact and dissipate the heat. In an embodiment of the present disclosure, the heat sink 180 may be attached to the lower surface of the circuit board 170, and the TEC 162 may be arranged on one side of the upper surface of the heat sink 180.

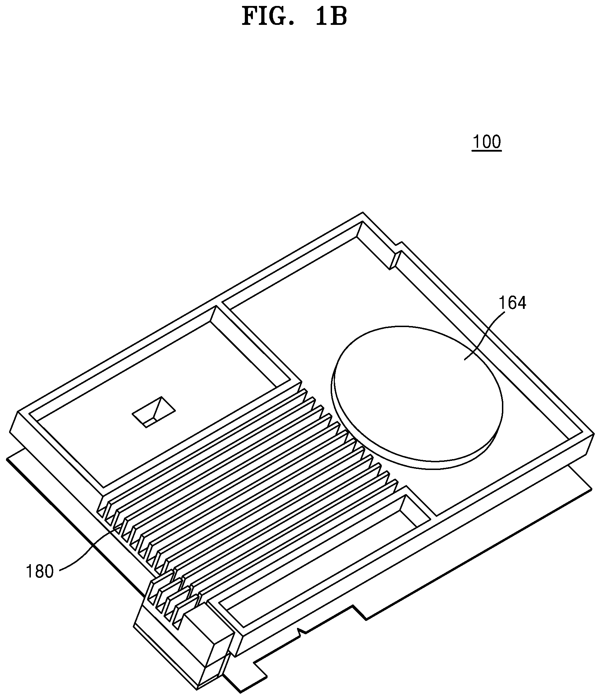

FIG. 1B is a rear view illustrating an exterior of the electronic device 100 according to an embodiment of the present disclosure.

Referring to FIG. 1B, the rear surface of the electronic device 100 may include a fan 164 and the heat sink 180.

The fan 164 may be arranged on the lower surface of the heat sink 180. The fan 164 is configured to cool the integrated circuit 120IC and the millimeter-wave communication module 122 of the communication module arranged on the circuit board 170, via air cooling through the heat sink 180 by using its rotating blades. In an embodiment of the present disclosure, the revolutions per minute (RPM) of the fan 164 may vary according to the magnitude of a voltage applied thereto. The fan 164 may be combined with the TEC 162 (see FIG. 1A) to constitute an active cooler.

The exterior of the electronic device 100 illustrated in FIGS. 1A and 1B is merely an example, and the electronic device 100 of the present disclosure is not limited to the structure illustrated in FIGS. 1A and 1B.

FIG. 2 is a block diagram illustrating components of the electronic device 100 according to an embodiment of the present disclosure.

Referring to FIG. 2, the electronic device 100 may include the sensors 110, the communication module 120, the processor 130, the memory 140, a voltage regulator 150, and an active cooler 160. The sensors 110, the communication module 120, the processor 130, the memory 140, the voltage regulator 150, and the active cooler 160 may be electrically and/or physically connected to each other. FIG. 2 illustrates only essential components for describing operations of the electronic device 100, and the components included in the electronic device 100 are not limited to those illustrated in FIG. 2. In an embodiment of the present disclosure, the electronic device 100 may further include the circuit board 170 (see FIG. 1A) and the heat sink 180 (see FIGS. 1A and 1B).

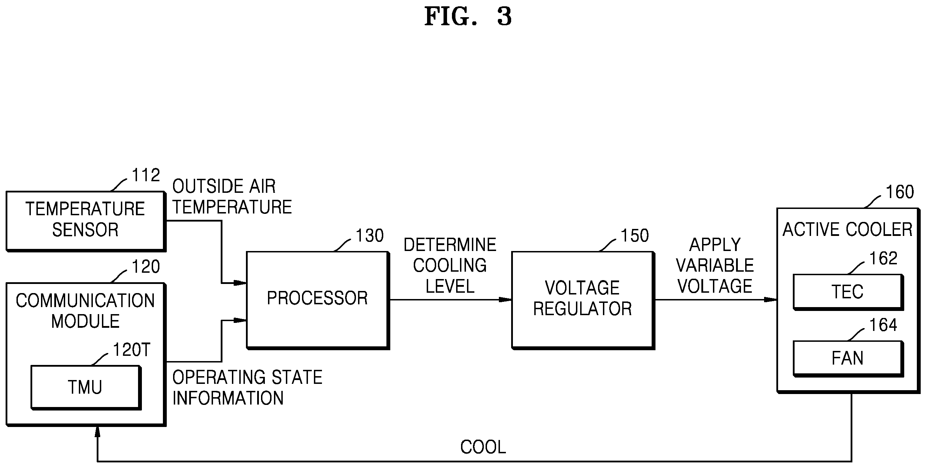

FIG. 3 is a diagram illustrating operations of components of the electronic device 100 and data transmitted and received between the components, according to an embodiment of the present disclosure.

Hereinafter, operations performed by the components of the electronic device 100 will be described with reference to FIGS. 2 and 3.

The sensors 110 include at least one sensor configured to sense information about an external environment of a vehicle or other vehicle-related information. Referring to FIG. 2, the sensors 110 may include a temperature sensor 112, a speed sensor 114, and a global navigation satellite system (GNSS) sensor 116.

The temperature sensor 112 is a sensor configured to measure an outside air temperature around the vehicle. Referring further to FIG. 3, the temperature sensor 112 may provide the processor 130 with information about the measured outside air temperature. In an embodiment of the present disclosure, the temperature sensor 112 may periodically monitor the outside air temperature at preset time intervals, and provide the measured outside air temperature to the processor 130 based on a monitoring result.

The speed sensor 114 is a sensor configured to detect the driving speed of the vehicle. The speed sensor 114 may provide the processor 130 with information about the driving speed of the vehicle.

The GNSS sensor 116 is a sensor configured to obtain information about the current position of the vehicle equipped with the electronic device 100, based on signals received from satellites. The GNSS sensor 116 may measure a time difference between a time point at which a signal has been transmitted from a satellite and a time point at which the signal has been received at the GNSS sensor 116, calculate the distance to the satellite by multiplying the time difference by a signal propagation speed, and determine an intersection as the current position of the vehicle.

The communication module 120 is a hardware device configured to perform data communication with a base station, a server, or other devices via a wireless communication network. In an embodiment of the present disclosure, the communication module 120 may include the millimeter-wave communication module 122 and the V2X communication module 124.

The millimeter-wave communication module 122 is a communication device configured to perform data communication in the frequency band between 30 GHz and 300 GHz. In an embodiment of the present disclosure, the millimeter-wave communication module 122 may include at least one hardware device among at least one antenna array, a modem, a switching circuit, an intermediate frequency integrated circuit (IFIC), and a thermal monitoring unit (TMU). The millimeter-wave communication module 122 may transmit and receive data via a communication channel established with a base station by using the at least one antenna array. The at least one antenna array may be a phased array antenna.

The V2X communication module 124 is a communication device configured to perform, while the vehicle is driving, data communication with road infrastructure or with communication devices of other vehicles, via a wireless communication network. In an embodiment of the present disclosure, the V2X communication module 124 may include at least one hardware device among a DSRC modem, a Wi-Fi module, a mobile communication module (e.g., an LTE, 5G, or 5G NR module), and an AP.

Although not illustrated in the drawings, the communication module 120 may further include a communication device configured to perform data communication by using various known communication methods, for example, short-range wireless data communication technologies such as wireless local area network (WLAN) (Wi-Fi), wireless broadband (Wibro), Worldwide Interoperability for Microwave Access (Wimax), Wi-Fi Direct, radio-frequency identification (RFID), Infrared Data Association (IrDA), ultra-wideband (UWB), ZigBee, near-field communication (NFC), or Bluetooth^{™}, and mobile communication network technologies such as code-division multiple access (CDMA), wideband code-division multiple access (WCDMA), 3G, and/or 4G LTE.

Referring further to FIG. 3, the communication module 120 may provide operating state information to the processor 130. The 'operating state information' may include information about at least one of power consumed by the communication module 120, and the temperature of the communication module 120. In the embodiment illustrated in FIG. 3, the communication module 120 may include a TMU 120T, and may measure the temperature of the communication module 120 via the TMU 120T, and provide the measured temperature value to the processor 130. In an embodiment of the present disclosure, the communication module 120 may provide the processor 130 with information about a power consumption value that changes upon turn-on of the integrated circuit 120IC (see FIG. 1A) constituting the millimeter-wave communication module 122 or the V2X communication module 124, a transmission output value of the V2X communication module 124, or a power consumption value resulting from a change in the number of operating antenna arrays among those included in the millimeter-wave communication module 122.

Referring again to FIG. 2, the processor 130 may execute one or more instructions of a program stored in the memory 140. The processor 130 may include a hardware component configured to perform arithmetic operations, logic operations, input/output operations, and image processing. The processor 130 is illustrated as a single element in FIG. 2, but is not limited thereto. In an embodiment of the disclosure, the processor 130 may consist of one or more elements. The processor 130 may be a general-purpose processor such as a CPU, an AP, or a digital signal processor (DSP), may be a dedicated graphics processor such as a graphics processing unit (GPU) or a vision processing unit (VPU), or may be a dedicated artificial intelligence processor such as a neural processing unit (NPU). The processor 130 may perform control to process input data according to predefined operation rules or an artificial intelligence model stored in the memory 140. Alternatively, in a case in which the processor 130 is a dedicated artificial intelligence processor, the dedicated artificial intelligence processor may be designed with a hardware structure specialized for processing a particular artificial intelligence model.

The memory 140 may include, for example, at least one of a flash memory-type storage medium, a hard disk-type storage medium, a multimedia card micro-type storage medium, a card-type memory (e.g., Secure Digital (SD) or eXtreme Digital (XD) memory), random-access memory (RAM), static RAM (SRAM), read-only memory (ROM), electrically erasable programmable ROM (EEPROM), programmable ROM (PROM), a magnetic memory, a magnetic disc, or an optical disc.

The memory 140 may store instructions associated with operations performed by the electronic device 100 for adaptive dynamic cooling. In an embodiment of the present disclosure, the memory 140 may store at least one of instructions, an algorithm, a data structure, program code, or an application program that is readable by the processor 130. The instructions, the algorithm, the data structure, and the program code stored in the memory 140 may be implemented in a programming or scripting language, for example, C, C++, Java, or an assembler.

Hereinafter, functions or operations performed by the processor 130 executing instructions or program code included in modules stored in the memory 140, will be described with reference to FIGS. 2 and 3.

The processor 130 may obtain, from the temperature sensor 112, information about an outside air temperature around the vehicle, and obtain, from the communication module 120, operating state information about at least one of power consumed by the communication module 120, and the temperature of the communication module 120. Based on the obtained ambient air temperature and operating state information about the communication module 120, the processor 130 may determine a cooling level for cooling the communication module 120 to a target temperature. In the present disclosure, a 'cooling level' represents cooling performance associated with cooling a cooling target by a certain temperature reduction amount. In an embodiment of the present disclosure, the cooling level may be determined in proportion to a temperature difference between the current temperature of the communication module 120 and a target temperature, i.e., a temperature reduction amount. For example, the processor 130 may determine a higher cooling level when the difference between the current temperature of the communication module 120, which is obtained from the TMU 120T, and a preset target temperature, i.e., a temperature reduction amount, is larger. As an opposite example, the processor 130 may determine a lower cooling level when the current temperature of the communication module 120 is similar to, or lower than, the target temperature.

In an embodiment of the present disclosure, the cooling level may also be determined based on an outside air temperature around the vehicle. For example, the cooling level may be determined to have a high value when the outside air temperature around the vehicle is high, and may be determined to have a low value when the outside air temperature around the vehicle is low.

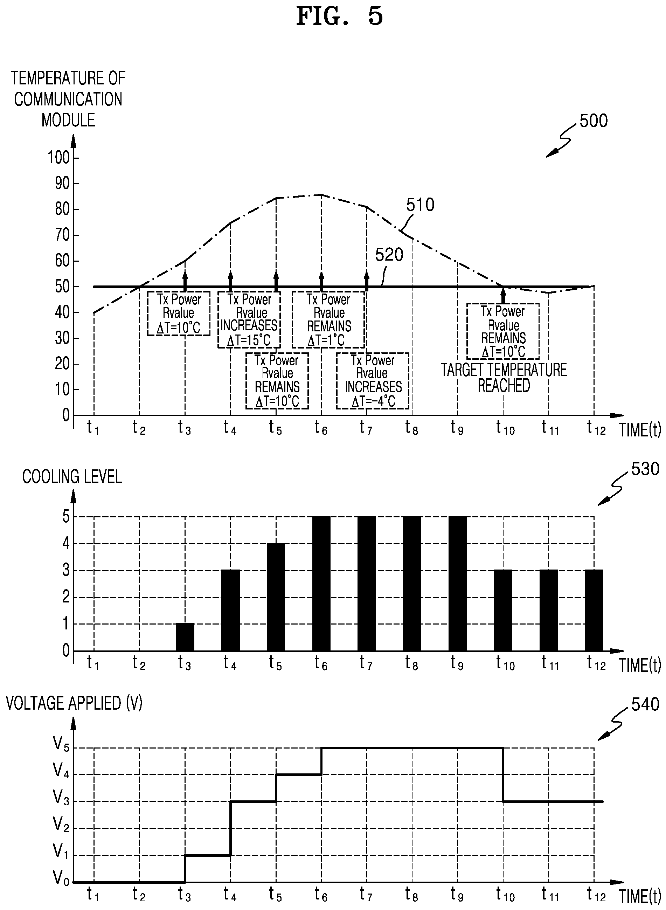

In an embodiment of the present disclosure, the processor 130 may monitor the outside air temperature around the vehicle and the operating state information about the communication module 120, at preset time intervals. The preset time interval may be, for example, 1 minute, but is not limited thereto. The processor 130 may periodically obtain, at preset time intervals, the outside air temperature around the vehicle and the operating state information about the communication module 120, and determine or adjust the cooling level based on the obtained outside air temperature and operating state information. For example, in a case that a result of monitoring at preset time intervals indicates that the outside air temperature around the vehicle or the temperature of the communication module 120 has increased, or that the power consumption of the communication module 120 has increased, the processor 130 may increase the cooling level. For example, in a case that a result of monitoring at preset time intervals indicates that the current temperature of the communication module 120 has been decreased to near the target temperature via cooling, the processor 130 may adjust the cooling level to a lower value. A detailed embodiment in which the processor 130 adjusts the cooling level based on the outside air temperature and the operating state information about the communication module 120 that are monitored at preset time intervals, will be described in detail below with reference to FIG. 5.

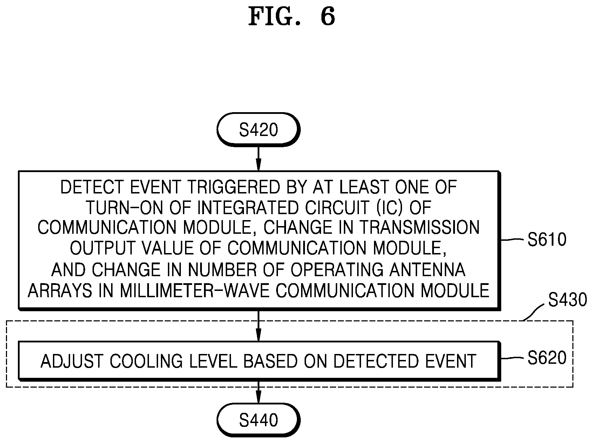

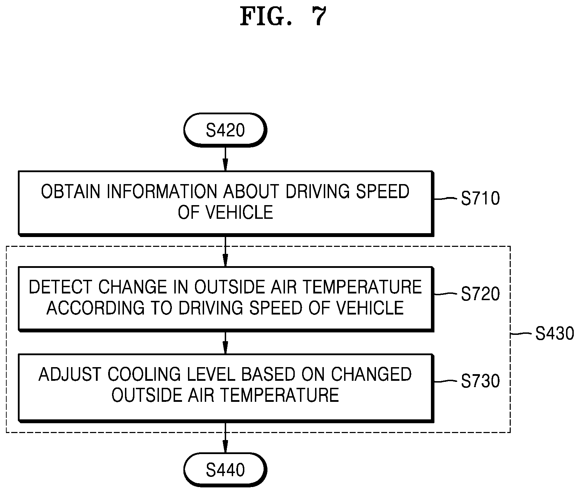

In an embodiment of the present disclosure, the processor 130 may detect an event triggered by at least one of a change in the operating state of the communication module 120, a change in the driving state of the vehicle, and a change in the outside air temperature, and determine, based on the detected event, a cooling level for lowering the temperature of the communication module 120. A detail embodiment in which the processor 130 determines, based on an event, the cooling level for the communication module 120 will be described in detail below with reference to FIGS. 6 and 7.

The processor 130 may transmit the determined or adjusted cooling level to the voltage regulator 150, and control the voltage regulator 150 to apply a variable voltage to the active cooler 160. The processor 130 may determine or adjust the cooling performance of the active cooler 160 according to the cooling level.

The voltage regulator 150 is a device configured to output a variable voltage value based on a voltage value input from a power supply device (not shown), by using jumpers or switching. Under control of the processor 130, the voltage regulator 150 may output a variable voltage value corresponding to the cooling level. The voltage regulator 150 may determine a voltage value to be output, based on the cooling level. In an embodiment of the present disclosure, the voltage value output by the voltage regulator 150 may be proportional to the cooling level determined by the processor 130. For example, the voltage value output by the voltage regulator 150 may be greater when the cooling level is higher, and may be smaller when the cooling level is lower. The variable voltage output by the voltage regulator 150 may be applied to the active cooler 160 as supply power.

The active cooler 160 includes the TEC 162 and the fan 164, and is configured to lower the temperature of the communication module 120 by using power applied thereto. The TEC 162 is a cooler including a Peltier element in which, when power is applied, heat is generated on one side while heat is dissipated from the other side so as to cool a cooling target. In an embodiment of the present disclosure, the cooling performance may be determined according to the voltage value applied to the TEC 162 by the voltage regulator 150. The fan 164 is a cooling device for air-cooling the communication module 120 via its rotating blades. In an embodiment of the present disclosure, the RPM of the fan 164 may be increased or decreased according to a voltage value applied by the voltage regulator 150.

The memory 140 may store a look-up table (LUT) 142 containing information about the correspondence relationship between cooling temperature values for the communication module 120 and voltage setting values for a variable voltage to be applied to the communication module 120. In an embodiment of the present disclosure, the LUT 142 may include information about voltage setting values for variable voltages to be applied respectively to the TEC 162 and the fan 164 according to respective cooling temperature values for each of the millimeter-wave communication module 122 and the V2X communication module 124 both included in communication module 120. In an embodiment of the present disclosure, the processor 130 may obtain, by loading the LUT 142 from the memory 140, a voltage setting value corresponding to a cooling temperature value for lowering the communication module 120 to a target temperature. The processor 130 may control the voltage regulator 150 to apply the obtained voltage setting value to the active cooler 160.

In an embodiment of the present disclosure, the LUT 142 may include a plurality of tables for a plurality of different outside air temperatures, respectively, each table including the correspondence relationship between cooling temperature values for the communication module 120 and voltage setting values to be applied. The processor 130 may select, from among the plurality of tables, the table corresponding to the outside air temperature around the vehicle, load the selected table, and obtain the voltage setting value for cooling the communication module 120 by the temperature reduction amount. The processor 130 may control the voltage regulator 150 to apply the obtained voltage setting value to the active cooler 160.

Although FIG. 2 illustrates that the LUT 142 is stored in the memory 140, the present disclosure is not limited thereto. In an embodiment of the present disclosure, the LUT 142 may be stored in a server or another device (e.g., a mobile device). In this case, the processor 130 may transmit a cooling temperature value to the server or other device via the communication module 120, and receive a voltage setting value corresponding to the cooling temperature value from the LUT stored in the server or other device.

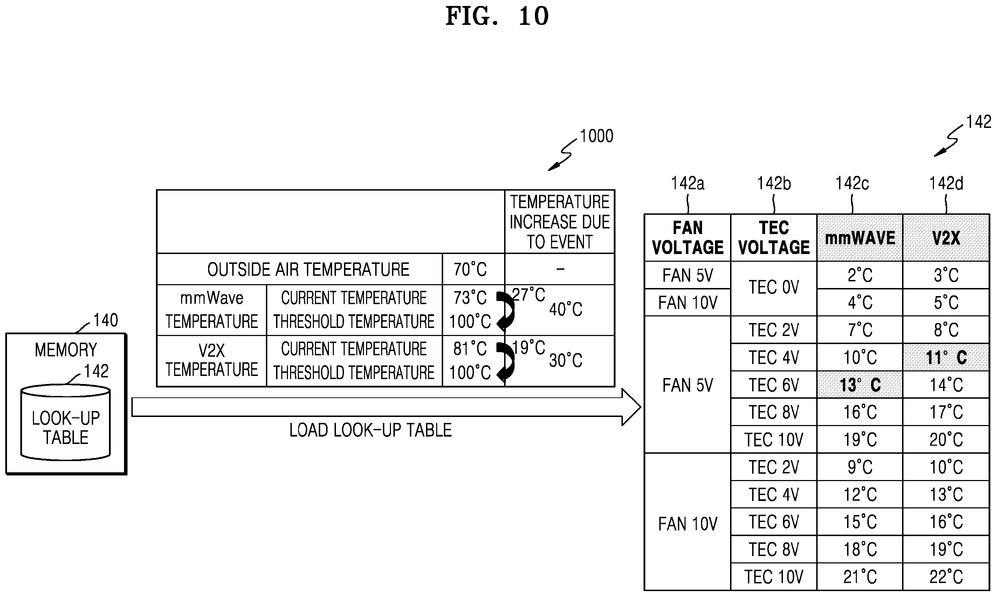

A detailed embodiment in which the processor 130 obtain information about a voltage setting value corresponding to a cooling temperature value for the communication module 120 by loading the LUT 142, and applies the voltage setting value to the active cooler 160, to cool the communication module 120 will be described in detail below with reference to FIGS. 10 to 12B.

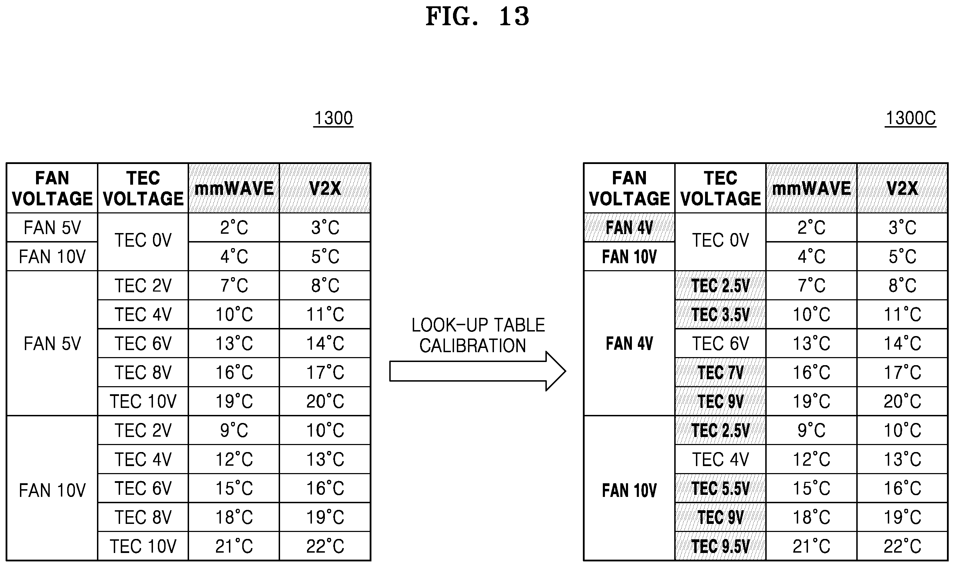

In an embodiment of the present disclosure, the processor 130 may calibrate the voltage setting values included in the LUT 142. A detailed embodiment in which the processor 130 calibrates the LUT 142 will be described in detail below with reference to FIG. 13.

Because the communication module 120 is arranged on the exterior structure of the vehicle, when the outside air temperature is high, the temperature of components included in the communication module 120, such as integrated circuits (ICs), increases, which may lead to degraded operational stability, including operational stoppage or performance degradation. In particular, during summer when the outside air temperature is high, the internal temperature of the vehicle rises to 100 °C or higher, and when the communication module 120 consumes power under these conditions, its internal components may experience a temperature increase to 100 °C or higher, leading to thermal issues. The maximum operating temperature for general communication modules is 105 °C, and in particular, communication modules using high frequencies, such as the millimeter-wave communication module 122, stop operating in a case that their temperature exceeds 80 °C. Furthermore, temperature control of the communication module 120 is essential to prevent issues regarding increased leakage current and reduced lifespan of integrated circuits due to the temperature of semiconductors constituting the communication module 120. For temperature control, employing uninterrupted cooling using a cooler presents an issue regarding high power consumption. In a case that uninterrupted cooling is not employed, the communication module 120 requires time to cool down, potentially rendering the communication module 120 inoperable when needed (e.g., for data transmission and reception with a base station).

An objective of the present disclosure is to provide an electronic device capable of performing adaptive dynamic cooling of the communication module 120 by applying a variable voltage to the active cooler 160, thereby securing operational stability of the communication module 120 and improving power consumption efficiency, and an operating method of the electronic device.

The electronic device 100 according to the embodiment illustrated in FIGS. 2 and 3 determines a cooling level based on an outside air temperature around the vehicle and operating state information about the communication module 120, and applies a variable voltage to the active cooler 160 according to the determined cooling level so as to cool the communication module 120, thereby providing the technical effects of minimizing power consumption through efficient cooling and ensuring operational stability of the communication module 120. Furthermore, the electronic device 100 according to an embodiment of the present disclosure obtains a voltage setting value corresponding to a cooling temperature value by loading the LUT 142 stored in the memory 140, applies the obtained voltage setting value to the active cooler 160 so as to cool the communication module 120, allowing the temperature of the communication module 120 to be controlled more precisely compared to related-art methods.

Although the electronic device 100 is illustrated and described in the embodiment of FIGS. 2 and 3 as lowering the temperature of the communication module 120, the present disclosure is not limited thereto. In an embodiment of the present disclosure, the active cooler 160 may be attached to another cooling target that includes an integrated circuit, for example, a lamp or an optical cable module mounted on a vehicle, and the electronic device 100 may cool the cooling target by applying a variable voltage to the active cooler 160 in the same manner as described above.

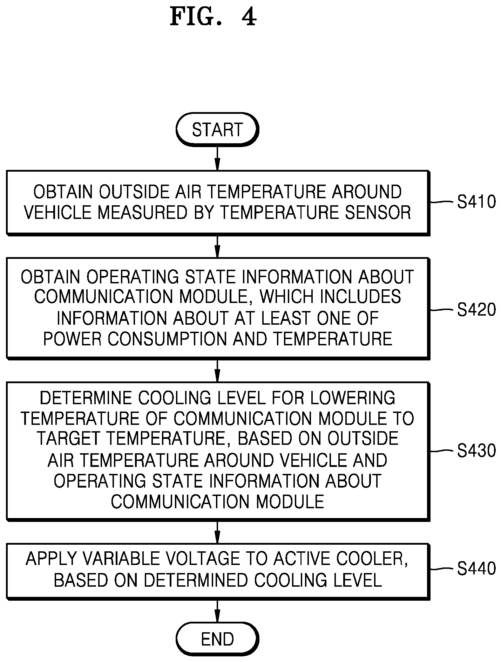

FIG. 4 is a flowchart of an operating method of the electronic device 100 according to an embodiment of the present disclosure.

In operation S410, the electronic device 100 obtains an outside air temperature around the vehicle measured by the temperature sensor. In an embodiment of the present disclosure, the electronic device 100 may periodically obtain, at preset time intervals, information about the outside air temperature from the temperature sensor, and monitor the outside air temperature.

In operation S420, the electronic device 100 obtains operating state information about the communication module, which includes information about at least one of power consumption and temperature. In an embodiment of the present disclosure, the communication module may include the millimeter-wave communication module 122 (see FIG. 2) and the V2X communication module 124 (see FIG. 2). In an embodiment of the present disclosure, the electronic device 100 may obtain information about a power consumption value resulting from turn-on of an integrated circuit constituting the communication module, a transmission output value of the communication module, or a power consumption value resulting from a change in the number of operating antenna arrays among those included in the millimeter-wave communication module 122. In an embodiment of the present disclosure, the communication module includes a TMU, and the electronic device 100 may obtain the temperature of the communication module measured via the TMU.

In an embodiment of the present disclosure, the electronic device 100 may monitor the power consumption and temperature of the communication module by obtaining operating state information about the communication module at preset time intervals.

In operation S430, the electronic device 100 determines a cooling level for lowering the temperature of the communication module to a target temperature, based on the outside air temperature around the vehicle and the operating state information about the communication module. In the present disclosure, a 'cooling level' represents cooling performance associated with cooling a cooling target by a certain temperature reduction amount. In an embodiment of the present disclosure, the electronic device 100 may determine the cooling level in proportion to a temperature difference between the current temperature of the communication module and a target temperature, i.e., a temperature reduction amount. For example, the electronic device 100 may determine a higher cooling level when the difference between the current temperature of the communication module and a preset target temperature, i.e., a temperature reduction amount, is larger. As an opposite example, the electronic device 100 may determine a lower cooling level when the current temperature of the communication module is similar to or lower than the target temperature.

In operation S440, the electronic device 100 applies a variable voltage to an active cooler, based on the determined cooling level. The active cooler is a device configured to cool a cooling target by using power applied thereto. In an embodiment of the present disclosure, the active cooler may include the TEC 162 (see FIG. 2) and the fan 164 (see FIG. 2), and may determine cooling performance according to the magnitude of a voltage applied as supply power. The electronic device 100 may determine the voltage value of the variable voltage to be applied to the active cooler, based on the cooling level. In an embodiment of the present disclosure, the electronic device 100 may determine the voltage value to be applied to the active cooler, in proportion to the cooling level. For example, the voltage value applied to the active cooler may be greater when the cooling level is higher, and may be smaller when the cooling level is lower.

FIG. 5 shows graphs 500, 530, and 540 for describing an operation, performed by the electronic device 100, of determining a cooling level and applying a variable voltage to an active cooler, according to an embodiment of the present disclosure.

Referring to the communication module temperature graph 500 among the graphs 500, 530, and 540 shown in FIG. 5, temperatures 510 of the communication module measured at constant time intervals and a target temperature 520 are shown. In the embodiment of FIG. 5, the target temperature 520 is determined as 50 °C, but this is merely an example, and the target temperature in the present disclosure is not limited to 50 °C.

In the communication module temperature graph 500, the time interval may be preset to a constant value or may be set by a user input. The time interval between a first time point t₁ and a second time point t₂ may be, for example, 1 minute, but is not limited thereto. In an embodiment of the present disclosure, the time interval may be increased or decreased based on an event detected resulting from a change in the operating state of the communication module and a change in the outside air temperature.

The electronic device 100 may monitor the temperature change of the communication module according to the time interval, and determine a cooling level based on a difference value between the current temperature of the communication module and a target temperature, i.e., a temperature reduction amount. In an embodiment of the present disclosure, the electronic device 100 may determine or adjust the cooling level based not only on the cooling temperature value but also on an event occurring in the communication module, for example, a change in a transmission output value, an increase or decrease in a power consumption value, or a temperature change. Referring to the communication module temperature graph 500 and the cooling level graph 530, at a third time point t₃, the temperature of the communication module is 60 °C, the target temperature is 50 °C, and thus, the cooling temperature value is 10 °C. At the third time point t₃, the electronic device 100 may increase the cooling level from 0 to 1. At a fourth time point t₄, because the temperature of the communication module has increased to 70 °C and the transmission output value has increased, the electronic device 100 may increase the cooling level by two steps, from 1 to 3. At a fifth time point t₅, the temperature of the communication module has increased to 80 °C with a 10 °C increase compared to the fourth time point t₄, and the transmission output value remains, and thus, the electronic device 100 may increase the cooling level from 3 to 4. At a sixth time point t₆, the transmission output value of the communication module remains, and the temperature of the communication module has increased by 1 °C compared to the fifth time point t₆, and thus, the electronic device 100 may increase the cooling level from 4 to 5. At a seventh time point t₇, the transmission output value of the communication module has decreased, and the temperature of the communication module has decreased by 4 °C compared to the sixth time point t₆, and thus, the electronic device 100 may maintain the cooling level at 5. At a tenth time point t₁₀, the transmission output value of the communication module remains, and the temperature of the communication module has decreased by 10 °C compared to a ninth time point t₉, and thus, the electronic device 100 may adjust the cooling level from 5 to 3.

The electronic device 100 may determine or adjust the voltage value of the variable voltage to be applied to the active cooler 160 (see FIGS. 2 and 3), based on the cooling level determined or adjusted according to the time interval. In an embodiment of the present disclosure, the processor 130 (see FIGS. 2 and 3) of the electronic device 100 may determine the cooling level and determine or adjust the voltage value of the variable voltage to be applied to the active cooler 160 via the voltage regulator 150 (see FIGS. 2 and 3). In an embodiment of the present disclosure, the processor 130 may increase or decrease the voltage value of the variable voltage to applied to the active cooler 160, in proportion to the cooling level.

Referring to the voltage graph 540 and the cooling level graph 530, the electronic device 100 may apply a voltage of V₀ to the active cooler at the first time point t₁, and at the third time point t₃ when the cooling level is increased from 0 to 1, increase the applied voltage value to V₁. In addition, at the fourth time point t₄ when the cooling level is increased from 1 to 3, the electronic device 100 may increase the voltage value applied to the active cooler, from V₁ to V₃. At the fifth time point t₅ when the cooling level is increased from 3 to 4, the electronic device 100 may increase the voltage value applied to the active cooler, from V₃ to V₄. At the sixth time point t₆ when the cooling level is increased from 4 to 5, the electronic device 100 may increase the voltage value applied to the active cooler, from V₄ to V₅. At the tenth time point t₁₀ when the cooling level is decreased from 5 to 3, the electronic device 100 may decrease the voltage value applied to the active cooler, from V₅ to V₃.

FIG. 6 is a flowchart of a method, performed by the electronic device 100, of adjusting a cooling level based on an event associated with a communication module, according to an embodiment of the present disclosure.

Operation S610 illustrated in FIG. 6 may be performed after operation S420 illustrated in FIG. 4 is performed. Operation S620 illustrated in FIG. 6 is a detailed operation of operation S430 illustrated in FIG. 4. After operation S620 illustrated in FIG. 6 is performed, operation S440 illustrated in FIG. 4 may be performed.

Referring to operation S610, the electronic device 100 detects an event triggered by at least one of turn-on of an integrated circuit of the communication module, a change in the transmission output value of the communication module, and a change in the number of operating antenna arrays in the millimeter-wave (mmWave) communication module. When an integrated circuit constituting the V2X communication module 124 (see FIG. 2) of the communication module is turned on, or when the number of operating antenna arrays in the millimeter-wave communication module of the communication module is changed, the transmission output value may change. In a case that the transmission output value of the communication module changes, the temperature of the communication module may rise. An example of the relationship between the transmission output value and temperature of the communication module is shown in Table 1 below.

**[Table 1]**

| Change in transmission output value of communication module | Change in temperature of communication module |
|---|---|
| 0 dBm | 0 °C |
| 5 dBm | 18 °C |
| 10 dBm | 19 °C |
| 15 dBm | 27 °C |
| 20 dBm | 33 °C |
| 23 dBm | 40 °C |

Referring to Table 1, in a case that the transmission output value of the communication module increases by 5 dBm, the temperature of the communication module may increase by 8 °C, and in a case that the transmission output value increases by 10 dBm, the temperature of the communication module may increase by 19 °C. The electronic device 100 may detect an event occurring in the communication module, and monitor a temperature change of the communication module at the time point the event is detected.

In operation S620, the electronic device 100 adjusts the cooling level based on the detected event. In response to the event being detected, the electronic device 100 may measure the temperature of the communication module and determine a cooling level for lowering the temperature of the communication module to a target temperature. In an embodiment of the present disclosure, the electronic device 100 may increase the cooling level in a case that the temperature of the communication module increases, and may adjust the cooling level to a lower value in a case that the temperature of the communication module decreases.

FIG. 7 is a flowchart of a method, performed by the electronic device 100, of adjusting a cooling level based on the driving speed of the vehicle, according to an embodiment of the present disclosure.

Operation S710 illustrated in FIG. 7 may be performed after operation S420 illustrated in FIG. 4 is performed. Operations S720 and S730 illustrated in FIG. 7 are detailed operations of operation S430 illustrated in FIG. 4. After operation S730 illustrated in FIG. 7 is performed, operation S440 illustrated in FIG. 4 may be performed.

Referring to operation S710, the electronic device 100 obtains information about the driving speed of the vehicle. In an embodiment of the present disclosure, the electronic device 100 may measure the driving speed of the vehicle via the speed sensor 114 (see FIG. 2).

In operation S720, the electronic device 100 detects a change in the outside air temperature according to the driving speed of the vehicle. As the driving speed of the vehicle increases, the outside air temperature may decrease. As the outside air temperature decreases, the temperature of the communication module mounted on the exterior structure of the vehicle may also decrease. For example, in a case that the vehicle travels at high speed for about 20 minutes, the temperature of the communication module may decrease by about 35 °C due to a decrease in the outside air temperature. In an embodiment of the present disclosure, the electronic device 100 may measure the driving speed of the vehicle at preset time intervals, and monitor a change in the outside air temperature according to the driving speed.

In operation S730, the electronic device 100 adjusts the cooling level based on the changed outside air temperature. In response to a change in the outside air temperature being detected, the electronic device 100 may measure the temperature of the communication module and determine a cooling level for lowering the temperature of the communication module to a target temperature. In an embodiment of the present disclosure, when a result of monitoring indicates that the outside air temperature has decreased due to an increase in the driving speed of the vehicle, the electronic device 100 may decrease the cooling level to a lower value.

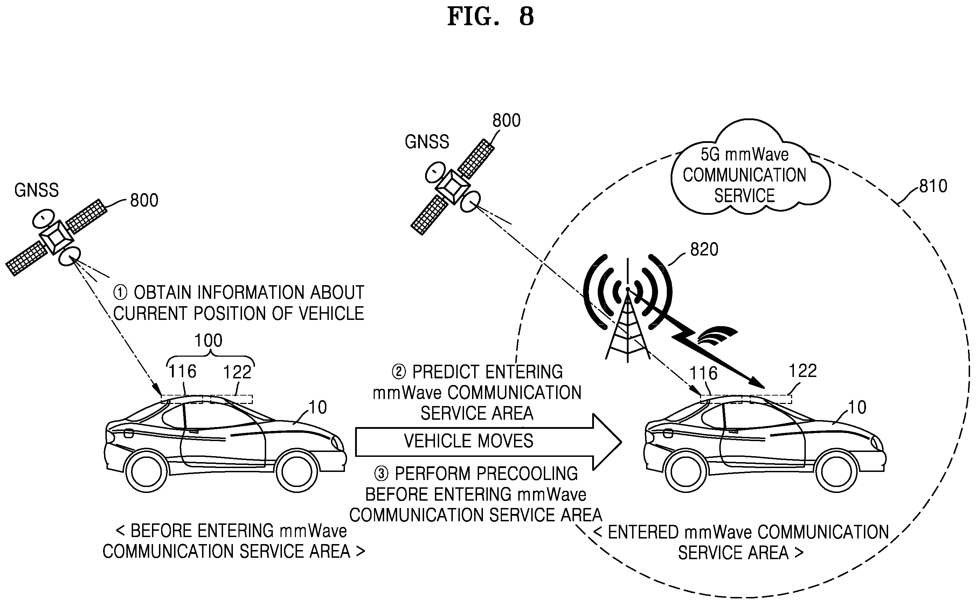

FIG. 8 is a diagram illustrating an operation, performed by the electronic device 100, of performing precooling based on a current position of a vehicle 10, according to an embodiment of the present disclosure.

Referring to FIG. 8, the electronic device 100 mounted on the vehicle 10 may include the GNSS sensor 116 and the millimeter-wave communication module 122. The GNSS sensor 116 may include a GNSS antenna, and may receive signals from a satellite 800 by using the GNSS antenna, and obtain information about the current position of the electronic device 100, based on the received signals. In an embodiment of the present disclosure, the processor 130 (see FIGS. 2 and 3) of the electronic device 100 may obtain, via the GNSS sensor 116, information about the current position of the vehicle 10 equipped with the electronic device 100 (operation ①). In the embodiment illustrated in FIG. 8, the current position of the vehicle 10 is outside a 5G millimeter-wave communication service area 810 where 5G NR millimeter-wave (mmWave) communication is available, and the vehicle 10 may be traveling in an area where 5G millimeter-wave communication is unavailable.

The electronic device 100 may predict, based on the driving speed and direction of the vehicle 10, that the vehicle 10 will enter the 5G millimeter-wave communication service area 810 (operation ②). The processor 130 of the electronic device 100 may periodically monitor the current position of the vehicle 10 via the GNSS sensor 116 at preset time intervals, and predict a time point at which the vehicle 10 will enter the 5G millimeter-wave communication service area 810, based on the speed of the vehicle 10 measured via the speed sensor 114 (see FIG. 2) and the monitored current position.

The electronic device 100 may perform precooling of the communication module before the vehicle 10 enters the 5G millimeter-wave communication service area 810 (operation ③). After the vehicle 10 enters the 5G millimeter-wave communication service area 810, an integrated circuit constituting the millimeter-wave communication module 122 is turned on, and data is transmitted to and received from a base station 820, and accordingly, the temperature of the millimeter-wave communication module 122 may rise. The processor 130 of the electronic device 100 may predict a time point at which the millimeter-wave communication module 122 will be turned on, and perform precooling before the time point of turn-on.

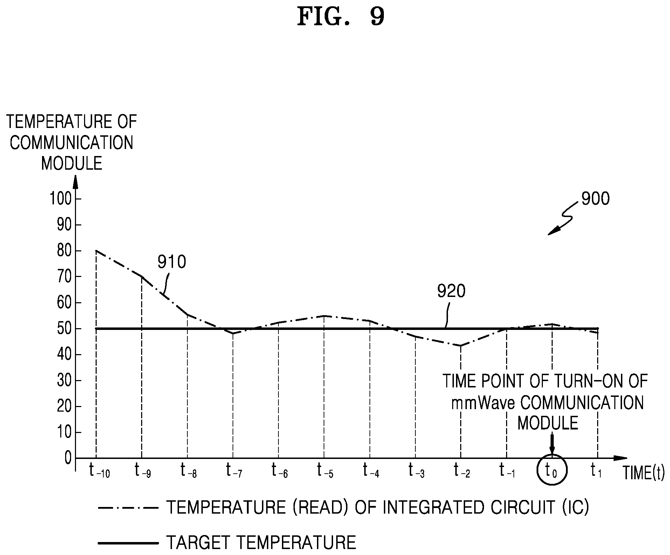

FIG. 9 is a communication module temperature graph 900 for describing an operation, performed by the electronic device 100, of performing precooling of the communication module, according to an embodiment of the present disclosure.

Referring to FIG. 8 together with the communication module temperature graph 900 illustrated in FIG. 9, the processor 130 (see FIGS. 2 and 3) of the electronic device 100 may predict a time point t₀ at which the vehicle 10 will enter the 5G millimeter-wave communication service area 810, based on the current position and driving speed of the vehicle 10, and anticipate that the millimeter-wave communication module 122 will be turned on at the predicted time point t₀. The processor 130 may perform precooling a preset time period before the time point t₀, in order to lower the temperature of the millimeter-wave communication module 122 in advance of t₀. In the embodiment illustrated in FIG. 9, the processor 130 may control the voltage regulator 150 (see FIGS. 2 and 3) to apply a voltage to the active cooler 160 (see FIGS. 2 and 3) at a time point t₋₁₀, which is earlier than t₀.

Referring to the communication module temperature graph 900 of FIG. 9, via precooling, a temperature 910 of the integrated circuit of the millimeter-wave communication module 122 continuously decreases from the time point t₋₁₀ until a time point t₋₇, and at the time point t₋₇, decreases to be close to a target temperature 920 of 50 °C. Subsequently, from a time point t₋₆ until the time point t₀ at which the millimeter-wave communication module 122 is expected to be turned on, the temperature 910 of the millimeter-wave integrated circuit fluctuates within a margin of error around the target temperature 920, to be lowered to the target temperature 920.

The electronic device 100 according to the embodiment illustrated in FIGS. 8 and 9 anticipates a temperature rise due to turn-on of a communication module (e.g., the millimeter-wave communication module 122) and performs precooling before the time point t₀ of operation of the communication module, so as to prevent a rapid temperature rise due to the operation of the communication module, thereby improving the operational stability of the communication module.

FIG. 10 is a diagram illustrating an LUT of voltage setting values of a variable voltage to be applied according to cooling temperature values for a communication module, according to an embodiment of the present disclosure.

Referring to FIG. 10, the LUT 142 may include information about the correspondence relationship between cooling temperature values for the communication module and voltage setting values for variable voltages to be applied to the fan 164 (see FIG. 2) and the TEC 162 (see FIG. 2) of the active cooler 160 (see FIGS. 2 and 3), respectively. The LUT 142 may be stored in the memory 140. The processor 130 (see FIGS. 2 and 3) of the electronic device 100 may load the LUT 142 from the memory 140 and, based on operating information 1000 about the outside air temperature and the temperature of the communication module, obtain a voltage setting value corresponding to a cooling temperature value for cooling the communication module to a target temperature.

Referring to the operating information 1000 in the embodiment illustrated in FIG. 10, the outside air temperature around the vehicle is 70 °C, the current temperature of the millimeter-wave communication module is 73 °C, and the current temperature of the V2X communication module is 81 °C. The temperature of the communication module may increase when an event associated with the communication module occurs, for example, turn-on of the communication module, an increase in the transmission output value of the communication module, or an increase in the number of operating antenna arrays in the millimeter-wave communication module. For example, when the event occurs, the temperature of the millimeter-wave communication module may increase by 40 °C, and the temperature of the V2X communication module may increase by 30 °C. When the temperature of the millimeter-wave communication module increases by 40 °C from the current temperature of 73 °C and thus reaches 113 °C, the millimeter-wave communication module needs to be cooled by 13 °C to keep its temperature at or below a threshold temperature of 100 °C. In addition, when the temperature of the V2X communication module increases by 30 °C from the current temperature of 81 °C and thus reaches 111 °C, the V2X communication module needs to be cooled by 11 °C to keep its temperature at or below a threshold temperature of 100 °C.

The processor 130 may reference a cooling temperature value 142c for the millimeter-wave communication module and a cooling temperature value 142d for the V2X communication module within the LUT 142 loaded from the memory 140, and obtain information about preset voltage setting values 142a and 142b for voltages to be applied to the active cooler to cool the communication module by the referenced cooling temperature values 142c and 142d, respectively. Referring to the embodiment illustrated in FIG. 10, the processor 130 may obtain, from the LUT 142, voltage setting values of 5 V and 6 V required to be applied respectively to the fan 164 and the TEC 162 in order to cool the millimeter-wave communication module by 13 °C. Similarly, the processor 130 may obtain, from the LUT 142, voltage setting values of 5 V and 4 V required to be applied respectively to the fan 164 and the TEC 162 in order to cool the V2X communication module by 11 °C.

The processor 130 may select the higher value from among the obtained voltage setting values, and control the voltage regulator 150 (see FIGS. 2 and 3) such that the selected voltage setting value is applied to the active cooler. In the embodiment illustrated in FIG. 10, the processor 130 may control the voltage regulator 150 to apply 5 V to the fan 164 and apply 6 V to the TEC 162.

Although the LUT 142 is described above and illustrated in FIG. 10 as being stored in the memory 140, the present disclosure is not limited thereto. In an embodiment of the present disclosure, the LUT 142 may be stored in a server or another device (e.g., a mobile device). In this case, the electronic device 100 may transmit a cooling temperature value to the server or other device, and receive a voltage setting value corresponding to a cooling temperature value from the LUT stored in the server or other device.

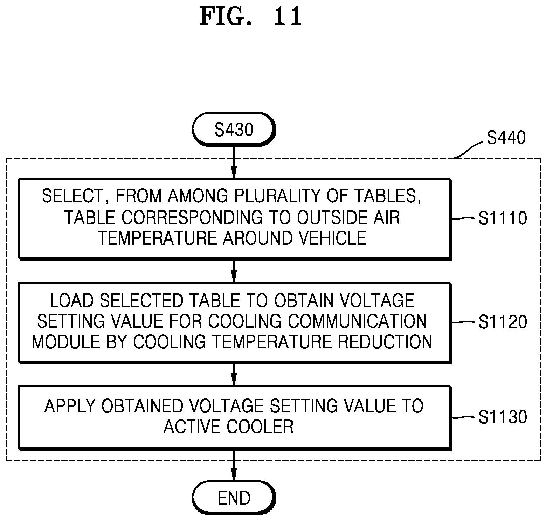

FIG. 11 is a flowchart of a method, performed by the electronic device 100, of selecting an LUT based on an outside air temperature around the vehicle, obtain a voltage setting value by loading the selected LUT, and applying the obtained voltage setting value to an active cooler, according to an embodiment of the present disclosure.

Operations S1110 to S1130 illustrated in FIG. 11 are detailed operations of operation S440 illustrated in FIG. 4. Operation S1110 illustrated in FIG. 11 may be performed after operation S430 illustrated in FIG. 4 is performed.

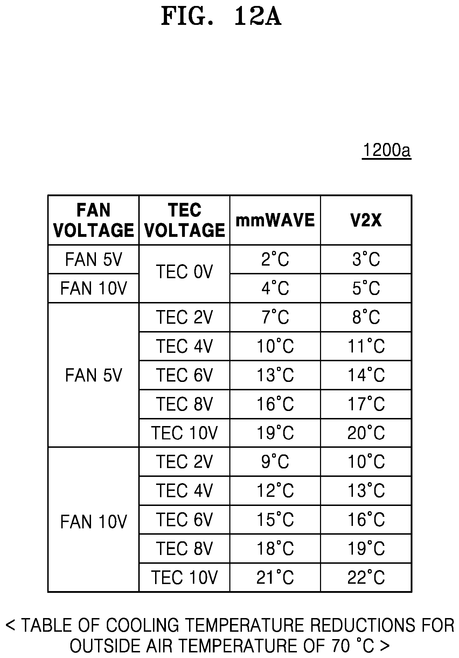

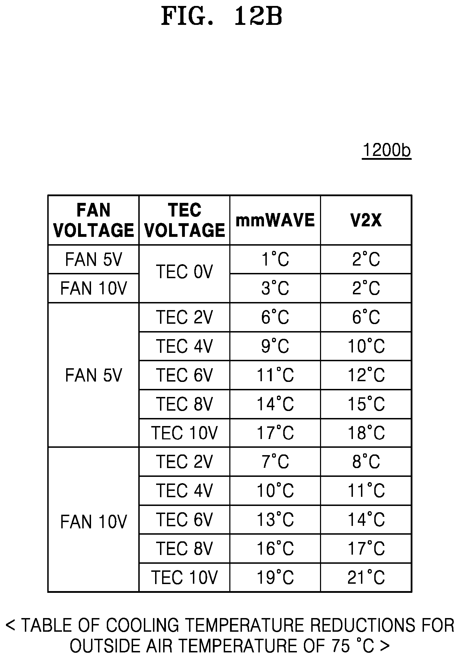

In operation S1110, the electronic device 100 selects, from among a plurality of tables, a table corresponding to the outside air temperature around the vehicle. In an embodiment of the present disclosure, the memory 140 (see FIGS. 2 and 10) may store a plurality of tables for a plurality of different outside air temperatures, respectively, each table including the correspondence relationship between cooling temperature values for the communication module and voltage setting values to be applied. The higher the outside air temperature, the greater the voltage value applied to the active cooler tends to be for cooling the communication module by the same temperature reduction amount. FIG. 12A is a diagram illustrating an example of an LUT 1200a including information about voltage setting values corresponding to cooling temperature values for a communication module when the outside air temperature is 70 °C. FIG. 12B is a diagram illustrating an example of an LUT 1200b including information about voltage setting values corresponding to cooling temperature values for a communication module when the outside air temperature is 75 °C. As illustrated in FIGS. 12A and 12B, the memory 140 may store a plurality of LUTs 1200a and 1200b containing information about voltage setting values to be applied to the active cooler according to cooling temperature values for the communication module, for different outside air temperatures, for example, 70 °C and 75 °C. The electronic device 100 may select, from among the plurality of LUTs 1200a and 1200b stored in the memory 140, the LUT corresponding to the current outside air temperature. For example, when the outside air temperature measured by the temperature sensor 112 (see FIGS. 2 and 3) is 70 °C, the electronic device 100 may select the LUT 1200a, which corresponds to an outside air temperature around 70 °C, from among the plurality of LUTs 1200a and 1200b.

In operation S1120, the electronic device 100 obtain, by loading the selected table, a voltage setting value for cooling the communication module by a temperature reduction amount. For example, when the outside air temperature around the vehicle is 70 °C, the electronic device 100 may select the LUT 1200a illustrated in FIG. 12A. In this case, the electronic device 100 may obtain, by loading the selected LUT 1200a, a voltage setting value required to be applied to the active cooler according to the cooling temperature value for cooling the communication module to a target temperature. For example, when the outside air temperature is 70 °C, the cooling temperature value for the millimeter-wave communication module is 16°C, and the cooling temperature value for the V2X communication module is 17 °C, the electronic device 100 may obtain 5 V as the voltage to be applied to the fan 164 and 8 V as the voltage to be applied to the TEC 162 by loading the LUT 1200a. For example, when the outside air temperature is 75 °C, the electronic device 100 may select the LUT 1200b illustrated in FIG. 12B and obtain information about voltage setting values to be applied respectively to the fan 164 and the TEC 162 by loading the selected LUT 1200b, according to the cooling temperature value for the millimeter-wave communication module and the cooling temperature value for the V2X communication module.

In operation S1130, the electronic device 100 applies the obtained voltage setting value to the active cooler. In an embodiment of the present disclosure, the electronic device 100 may control the voltage regulator 150 (see FIGS. 2 and 3) to apply, to the active cooler, power according to the voltage setting value obtained from the LUT 1200a or 1200b.

In the embodiment illustrated in FIGS. 10 to 12B, the electronic device 100 obtain, by loading the LUT 142, 1200a, or 1200b, voltage setting values for variable voltages to be applied to the TEC 162 and the fan 164 according to a cooling temperature value for lowering the temperature of the communication module to a target temperature, and apply, to the active cooler, power according to the obtained voltage setting values so as to cool the communication module, thereby providing cooling performance optimized according to power consumption. In addition, the electronic device 100 according to an embodiment of the present disclosure refers to the LUT 142, 1200a, or 1200b to apply, as supply power to the active cooler, an optimal voltage corresponding to a cooling temperature value, thereby minimizing power consumption and improving cooling efficiency.

FIG. 13 is a diagram for describing an operation, performed by the electronic device 100, of calibrating voltage setting values of an LUT 1300, according to an embodiment of the present disclosure.

When the LUT 1300, which contains information about cooling temperature values for the communication module and voltage setting values to be applied to the active cooler, is applied to vehicles in large quantities, the accuracy of the voltage setting values may decrease due to sample variations. Furthermore, the voltage setting value corresponding to a cooling temperature value may vary depending on the position on the exterior structure of the vehicle where the communication module is arranged. The electronic device 100 according to an embodiment of the present disclosure may monitor, during a pre-delivery test on a complete vehicle or when driving of a vehicle is stopped, the voltage value of the variable voltage applied to the active cooler to cool the communication module mounted on the vehicle to a desired target temperature, to calibrate the voltage setting values of the LUT 1300.

Referring to the LUT 1300 before calibration, for example, it is set to apply power of 5 V to the fan 164 (see FIG. 2) and apply power of 2 V to the TEC 162 (see FIG. 2) to cool the millimeter-wave communication module by 7 °C and cool the V2X communication module by 8 °C, whereas, referring to an LUT 1300C after calibration, the voltage setting values may be changed such that power of 4 V is applied to the fan 164 and power of 2.5 V is applied to the TEC 162 to achieve the same cooling temperature values. For example, referring to the LUT 1300 before calibration, it is set to apply power of 10 V to the fan 164 and apply power of 2 V to the TEC 162 to cool the millimeter-wave communication module by 9 °C and cool the V2X communication module by 10 °C, whereas, referring to the LUT 1300C after calibration, the voltage setting values may be changed such that power of 2.5 V is applied to the TEC 162 to achieve the same cooling temperature values.

Referring to the LUT 1300C after calibration, it shows that, via calibration, the voltage setting value to be applied to the fan 164 to cool the millimeter-wave communication module by 2 °C has been modified from 5 V to 4 V. In addition, the voltage setting values to be applied to the TEC 162 for cooling the millimeter-wave communication module by 7 °C, 9 °C, 10 °C, 15 °C, 16 °C, 18 °C, 19 °C, and 21 °C, and for cooling the V2X communication module by 8 °C, 10 °C, 11 °C, 16 °C, 17 °C, 19 °C, 20 °C, and 22 °C have been modified. The shaded portions in the post-calibration LUT 1300C of FIG. 13 represent the voltage setting values modified via calibration.

The electronic device 100 according to the embodiment illustrated in FIG. 13 calibrates the voltage setting values of the LUT 1300, thereby minimizing errors arising from sample variations or the arrangement position of the communication module in the vehicle, minimizing power consumption, and improving cooling efficiency.

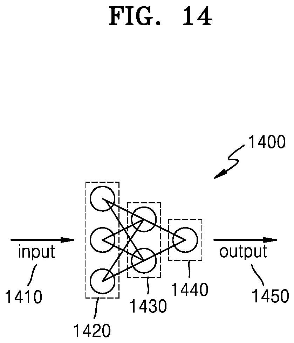

FIG. 14 is a diagram for describing an operation performed by the electronic device 100 using artificial intelligence technology, according to an embodiment of the present disclosure.

In detail, at least one of i) determining a cooling level for lowering the temperature of the communication module to a target temperature based on the outside air temperature around the vehicle and operating state information about the communication module, and ii) performing adaptive dynamic cooling of the communication module by applying a variable voltage to the active cooler according to the determined cooling level, which are performed by the electronic device 100, may be carried out by using artificial intelligence (AI) technology for performing computations via a neural network.

AI technology is for obtaining an intended result by performing processing, such as analysis and/or classification, on input data based on computations through a neural network.

AI technology may be implemented by using an algorithm. Here, an algorithm or a set of algorithms for implementing Al technology is referred to as a neural network. Here, the neural network may receive an input of input data, perform computations for analysis and/or classification, and output resulting data. In order for the neural network to accurately output resulting data corresponding to input data, it is necessary to train the neural network. Here, 'training' may refer to training the neural network to discover or learn by itself a method of analyzing pieces of input data to the neural network, a method of classifying the pieces of input data, and/or a method of extracting features required for generating resultant data from the pieces of input data. In detail, through a training process, the neural network may be trained based on training data (e.g., a plurality of different images) so as to optimize and set weight values in the neural network. Then, the neural network having the optimized weight values may output an intended result by processing input data.

Neural networks that include a plurality of hidden layers for performing computations, i.e., the depth of which for performing computations increases, may be classified as deep neural networks. Examples of neural networks include, but are not limited to, convolutional neural networks (CNNs), recurrent neural networks (RNNs), restricted Boltzmann machines (RBMs), deep belief networks (DBNs), bidirectional recurrent deep neural networks (BRDNNs), and deep Q-networks (DQNs). Furthermore, neural networks may be subdivided. For example, CNNs may be subdivided into deep CNNs (DCNNs), capsule neural networks (CapsNets) (not shown), and the like.

An 'Al model' may refer to a neural network including at least one layer configured to receive input data and output a desired result. An 'Al model' may also refer to an algorithm or a set of a plurality of algorithms for outputting an intended result by performing computations through a neural network, a processor for executing the algorithm (or the set of algorithms), software for executing the algorithm (or the set of algorithms), or hardware for executing the algorithm (or the set of algorithms).

At least one of i) determining a cooling level for lowering the temperature of the communication module to a target temperature, based on an outside air temperature around the vehicle and operating state information about the communication module, and ii) performing adaptive dynamic cooling of the communication module by applying a variable voltage to the active cooler according to the determined cooling level, which are described above, may be performed based on an Al model.

Referring to FIG. 14, a neural network 1400 may be trained by receiving an input of training data. Subsequently, the trained neural network 1400 may receive input data 1410 via an input stage 1420, and the input stage 1420, a hidden layer 1430, and an output stage 1140 may perform computations to analyze the input data 1410 and data transferred from previous layers, and thus output output data 1450. Although FIG. 14 illustrates the hidden layer 1430 as a single layer, this is merely an example, and the hidden layer 1430 may include a plurality of layers.

In the disclosed embodiment, the neural network 1400 may be trained to detect an event triggered by at least one of a change in the operating state of the communication module, a change in the driving state of the vehicle, and a change in the temperature, and determine, based on the detected event, a cooling level for lowering the temperature of the communication module.

In the disclosed embodiment, the neural network 1400 may be trained to detect an event triggered by at least one of turn-on of an integrated circuit included in the communication module, a change in the transmission output value of the communication module, and a change in the number of operating antenna arrays in the millimeter-wave communication module, and adjust the cooling level based on the detected event.

In the disclosed embodiment, the neural network 1400 may be trained to adjust the cooling level based on the outside air temperature that has changed according to the driving speed of the vehicle.

In the disclosed embodiment, the neural network 1400 may be trained to, when the vehicle is currently traveling at a position adjacent to a millimeter-wave communication service area, perform precooling by applying a variable voltage to the active cooler before the vehicle enters the millimeter-wave communication service area.

In the disclosed embodiment, data or program code associated with the neural network 1400 for performing at least one of i) determining a cooling level for lowering the temperature of the communication module to a target temperature, based on an outside air temperature around the vehicle and operating state information about the communication module, and ii) performing adaptive dynamic cooling of the communication module by applying a variable voltage to the active cooler according to the determined cooling level, which are described above, is stored in the memory 140 (see FIG. 2), and training of the neural network 1400 may be performed by the processor 130 (see FIG. 2). In this case, the processor 130 may include an Al processor.

Alternatively, the neural network 1400 configured to perform at least one of i) determining a cooling level for lowering the temperature of the communication module to a target temperature, based on an outside air temperature around the vehicle and operating state information about the communication module, and ii) performing adaptive dynamic cooling of the communication module by applying a variable voltage to the active cooler according to the determined cooling level, which are described above, may be implemented within a separate device (not shown) or processor (not shown) distinct from the electronic device 100.

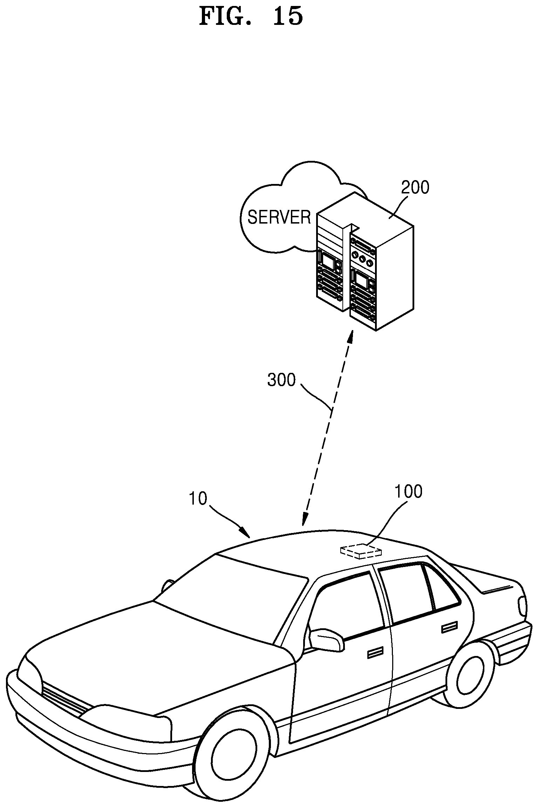

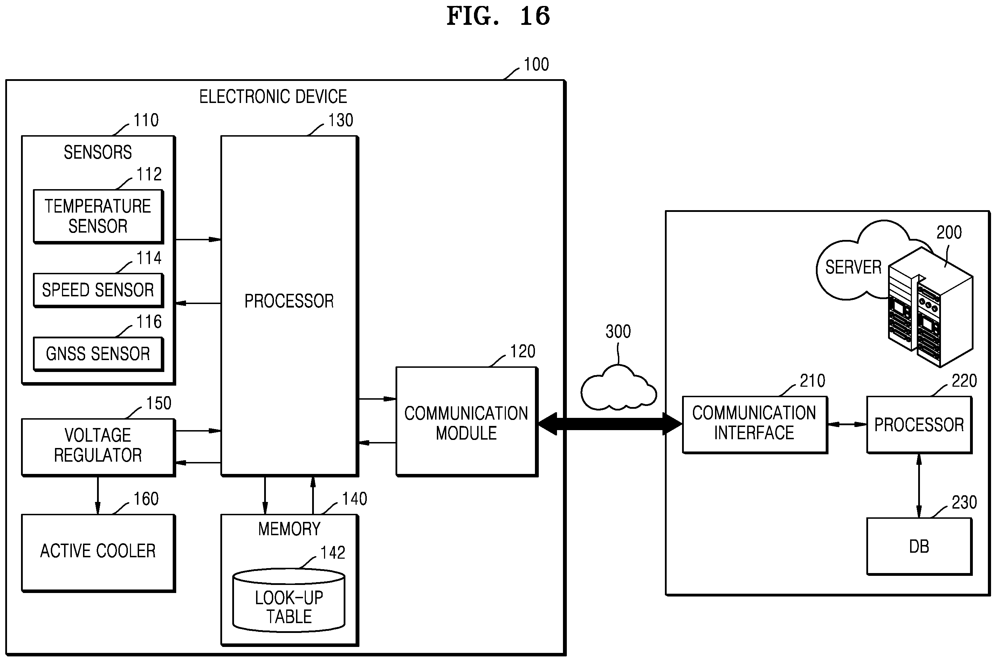

The computations via the neural network 1400 described above may be performed by a server 200 (see FIGS. 15 and 16) capable of communicating with the electronic device 100 according to an embodiment, via a wireless communication network. Communication between the electronic device 100 and the server 200 will be described with reference to FIGS. 15 and 16.

FIG. 15 is a diagram illustrating the electronic device 100 operating in conjunction with the server 200, according to an embodiment of the present disclosure.

The server 200 may transmit and receive data to and from the electronic device 100 via a communication network 300, and process data.

Referring further to FIG. 16, the server 200 may include a communication unit 210 configured to communicate with the electronic device 100, a processor 220 configured to execute at least one instruction, and a database 230.

The server 200 may train an Al model and store the trained Al model. In addition, by using the trained Al model, the server 200 may perform at least one of i) determining a cooling level for lowering the temperature of the communication module to a target temperature based on the outside air temperature around the vehicle and operating state information about the communication module, and ii) performing adaptive dynamic cooling of the communication module by applying a variable voltage to the active cooler according to the determined cooling level, which are described above.

In general, the electronic device 100 may have limitations compared to the server 200 regarding the storage capacity of the memory 140 (see FIG. 2), the computation processing speed of the processor 130 (see FIGS. 2 and 3), the ability to collect training datasets, and the like. Thus, operations requiring the storage of large-capacity data and significant computational load may be performed on the server 200, after which necessary data and/or Al model may be transmitted to the electronic device 100 via a communication network. Accordingly, the electronic device 100 may quickly and easily perform necessary operations even without a large-capacity memory and a processor with high-speed computation capabilities, by receiving and utilizing necessary data and/or Al model via the server 200.

In the disclosed embodiment, the server 200 may include the neural network 1400 described above with reference to FIG. 14.

FIG. 16 is a diagram for describing FIG. 15 in detail.

Referring to FIG. 16, the server 200 may include the communication unit 210, the processor 220, and the database 230.

The communication unit 210 performs communication with an external device via a wireless communication network. Here, the external device (not shown) may include a server capable of performing at least one of computations required by the electronic device 100, or transmitting data required by the electronic device 100.

The communication unit 210 includes at least one communication module such as a short-range communication module, a wired communication module, a mobile communication module, or a broadcast receiving module. Here, the at least one communication module refers to a communication module capable of performing transmission and reception of data through a tuner performing broadcast reception, or a network conforming to a communication specification such as Bluetooth, WLAN (e.g., Wi-Fi), Wibro, WiMAX, CDMA, WCDMA, Internet, 3G, 4G, 5G, and/or communication schemes using millimeter waves (mmWave).

The mobile communication module included in the communication unit 210 may perform communication with another device located remotely (e.g., the electronic device 100) via a communication network conforming to communication standards such as 3G, 4G (LTE), and/or 5G. Here, the communication module configured to perform communication with another device located remotely may be referred to as a 'long-range communication module'. In an embodiment of the present disclosure, the communication unit 210 of the server 200 may transmit and receive data to and from the communication module 120 of the electronic device 100 in a wired or wireless manner.

The processor 220 controls the overall operation of the server 200. For example, the processor 220 may perform required operations by executing at least one instruction or programs of the server 200.

The database 230 may include a memory (not shown) and may store, in the memory (not shown), at least one of at least one instruction, program, or data necessary for the server 200 to perform certain operations. In addition, the database 230 may store data necessary for the server 200 to perform computations according to a neural network.

In the disclosed embodiment, the server 200 may store the neural network 1400 described above with reference to FIG. 14. The neural network 1400 may be stored in at least one of the processor 220 and the database 230. The neural network 1400 included in the server 200 may be a fully trained neural network.

In addition, the server 200 may transmit the trained neural network 1400 (see FIG. 14) to the communication module 120 of the electronic device 100 via the communication unit 210. The electronic device 100 may obtain and store the trained neural network 1400, and obtain desired output data via the neural network 1400.

The present disclosure provides an electronic device 100 mounted on a vehicle 10. The electronic device 100 according to an embodiment of the present disclosure may include a sensor 110 including a temperature sensor 112, a communication module 120 including at least one of a millimeter-wave communication module 122 and a V2X communication module 124, an active cooler 160 including a TEC 162 and a fan 164, and configured to lower a temperature of the communication module 120 according to applied power, a voltage regulator 150 configured to adjust operating power applied to the active cooler 160, a memory 140 storing at least one instruction, and at least one processor 130 configured to execute the at least one instruction. The at least one processor 130 may obtain an outside air temperature around the vehicle 10 measured by the temperature sensor 112. The at least one processor 130 may obtain operating state information about the communication module 120, the operating state information including information about at least one of a power consumption and a temperature of the communication module 120. The at least one processor 130 may determine, based on the outside air temperature around the vehicle 10 and the operating state information about the communication module 120, a cooling level for lowering the temperature of the communication module 120 to a target temperature. The at least one processor 130 may control the voltage regulator 150 to apply a variable voltage to the active cooler 160 based on the determined cooling level.

In an embodiment of the present disclosure, The at least one processor 130 may detect an event triggered by at least one of a change in an operating state of the communication module 120, a change in a driving state of the vehicle, and a change in the outside air temperature. The at least one processor 130 may determine, based on the detected event, the cooling level for lowering the temperature of the communication module 120.

In an embodiment of the present disclosure, the at least one processor 130 may detect an event triggered by at least one of turn-on of an integrated circuit included in the communication module 120, a change in a transmission output value of the communication module 120, and a change in a number of operating antenna arrays in the millimeter-wave communication module. The at least one processor 130 may obtain adjust the cooling level based on the detected event.

In an embodiment of the present disclosure, the at least one processor 130 may obtain, from a speed sensor 114, information about a driving speed of the vehicle 10, and detect the outside air temperature that has changed according to the driving speed of the vehicle. The at least one processor 130 may adjust the cooling level based on the changed outside air temperature.

In an embodiment of the present disclosure, the at least one processor 130 may obtain the outside air temperature around the vehicle 10 and the operating state information about the communication module 120 by monitoring the outside air temperature and the operating state information about the communication module 120 at preset time intervals.

In an embodiment of the present disclosure, the at least one processor 130 may increase or decrease the time interval based on an event detected resulting from a change in the operating state of the communication module 120 or a change in the outside air temperature, or based on an expected operating time point of the communication module 120.

In an embodiment of the present disclosure, the electronic device 100 may further include a GNSS sensor 116 configured to obtain information about the current position of the vehicle 10. In a case that the current position of the vehicle 10 obtained by the GNSS sensor 116 is adjacent to a millimeter-wave communication service area where the millimeter-wave communication module 122 is expected to be turned on, the at least one processor 130 may perform precooling by applying a variable voltage to the active cooler 160 before the vehicle 10 enters the millimeter-wave communication service area.

In an embodiment of the present disclosure, a look-up table LUT 142 including information about a correspondence relationship between cooling temperature values for the communication module 120 and voltage setting values for a variable voltage to be applied to the communication module 120 is stored in a storage in the memory 140. The at least one processor 130 may obtain, by loading the LUT 142 from the memory 140, a voltage setting value corresponding to a cooling temperature value for lowering the temperature of the communication module 120 to the target temperature. The at least one processor 130 may control the voltage regulator 150 to apply the obtained voltage setting value to the active cooler 160.

In an embodiment of the present disclosure, the LUT 142 may include a plurality of tables for a plurality of different outside air temperatures, respectively, each of the plurality of tables including a correspondence relationship between the cooling temperature values and voltage setting values. The at least one processor 130 may select, from among the plurality of tables, a table corresponding to the outside air temperature around the vehicle, and obtain a voltage setting value for cooling the communication module 120 by the temperature reduction amount by loading the selected table from the memory 140.

In an embodiment of the present disclosure, the at least one processor 130 may calibrate the voltage setting values included in the LUT 142 by monitoring a relationship between the variable voltage applied to the communication module 120 and the cooling temperature value for the communication module 120 according to the outside air temperature around the vehicle, upon delivery of the vehicle or when operation of the vehicle is stopped.

The present disclosure provides an operation method of an electronic device 100 mounted on a vehicle. In an embodiment of the present disclosure, the operating method of the electronic device 100 may include obtaining an outside air temperature around the vehicle 10 measured by a temperature sensor 112 (S410). In an embodiment of the present disclosure, the operating method of the electronic device 100 may include obtaining operating state information about a communication module 120, the operating state information including information about at least one of a power consumption and a temperature of at least one of a millimeter-wave (mmWave) communication module 122 and a V2X communication module 124 (S420). In an embodiment of the present disclosure, the operating method of the electronic device 100 may include determining, based on the outside air temperature and the operating state information about the communication module 120, a cooling level for lowering a temperature of the communication module 120 to a target temperature (S430). In an embodiment of the present disclosure, the operating method of the electronic device 100 may include applying, based on the determined cooling level, a variable voltage to an active cooler 160 (S440).

In an embodiment of the present disclosure, the operating method of the electronic device 100 may further include detecting an event triggered by at least one of a change in an operating state of the communication module 120, a change in a driving state of the vehicle, and a change in the outside air temperature. In an embodiment of the present disclosure, the determining of the cooling level (S430) may include determining, based on the detected event, the cooling level for lowering the temperature of the communication module 120.

In an embodiment of the present disclosure, the detecting of the event may include detecting an event triggered by at least one of turn-on of an integrated circuit included in the communication module 120, a change in a transmission output value of the communication module 120, and a change in a number of operating antenna arrays in the millimeter-wave communication module (S610). In an embodiment of the present disclosure, the determining of the cooling level (S430) may include adjusting the cooling level based on the detected event (S620).

In an embodiment of the present disclosure, the operating method of the electronic device 100 may further include obtaining, from a speed sensor, information about a driving speed of the vehicle (S710). In an embodiment of the present disclosure, the detecting of the event may include detecting the outside air temperature that has changed according to the driving speed of the vehicle (S720), and the determining of the cooling level (S430) may include adjusting the cooling level based on the changed outside air temperature (S730).

In an embodiment of the present disclosure, in the obtaining of the outside air temperature and the obtaining of the operating state information about the communication module 120, the electronic device 100 may obtain the outside air temperature around the vehicle and the operating state information about the communication module 120 by monitoring the outside air temperature and the operating state information about the communication module 120 at preset time intervals.

In an embodiment of the present disclosure, the operating method of the electronic device 100 may further comprise obtaining information about the current position of the vehicle by using a GNSS. In an embodiment of the present disclosure, in the applying of the variable voltage to the active cooler 160 (S440), in a case that the current position of the vehicle is adjacent to a millimeter-wave communication service area where the millimeter-wave communication module is expected to be turned on, the electronic device 100 may perform precooling by applying a variable voltage to the active cooler 160 before the vehicle enters the millimeter-wave communication service area.

In an embodiment of the present disclosure, a look-up table LUT 142 including information about a correspondence relationship between cooling temperature values for the communication module 120 and voltage setting values for a variable voltage to be applied to the communication module 120 is stored in a storage in the memory 140 of the electronic device 100. In an embodiment of the present disclosure, the applying of the variable voltage to the active cooler 160 (S440) may include obtaining, by loading the LUT 142 from the memory 140, a voltage setting value corresponding to a cooling temperature value for lowering the temperature of the communication module 120 to the target temperature, and applying the obtained voltage setting value to the active cooler 160.

In an embodiment of the present disclosure, the LUT 142 may include a plurality of tables for a plurality of different outside air temperatures, respectively, each of the plurality of tables including a correspondence relationship between the cooling temperature values and voltage setting values. The obtaining of the voltage setting value corresponding to the cooling temperature value may include selecting, from among the plurality of tables, a table corresponding to the outside air temperature around the vehicle (S1110), and obtaining the voltage setting value for cooling the communication module 120 by the cooling temperature value by loading the selected table (S1120).

In an embodiment of the present disclosure, the operating method of the electronic device 100 may further include calibrating the voltage setting values included in the LUT 142 by monitoring a relationship between the variable voltage applied to the communication module 120 and the cooling temperature value for the communication module 120 according to the outside air temperature around the vehicle, upon delivery of the vehicle or when operation of the vehicle is stopped.

The present disclosure provides a computer program product including a computer-readable storage medium. The storage medium may include instructions readable by an electronic device 100, the instructions causing the electronic device 100 to perform obtaining an outside air temperature around a vehicle 10 measured by a temperature sensor 112, obtaining operating state information about a communication module 120, the operating state information including information about at least one of a power consumption and a temperature of at least one of a millimeter-wave (mmWave) communication module 122 and a V2X communication module 124, determining, based on the outside air temperature and the operating state information about the communication module 120, a cooling level for lowering a temperature of the communication module 120 to a target temperature, and applying, based on the determined cooling level, a variable voltage to an active cooler 160.

A program executable by the electronic device 100 described herein may be implemented as a hardware component, a software component, and/or a combination of hardware components and software components. The program is executable by any system capable of executing computer-readable instructions.

The software may include a computer program, code, instructions, or a combination of one or more thereof, and may configure the processor to operate as desired or may independently or collectively instruct the processor.

The software may be implemented as a computer program that includes instructions stored in computer-readable storage media. The computer-readable storage media may include, for example, magnetic storage media (e.g., ROM, RAM, floppy disks, or hard disks) and optical storage media (e.g., a compact disc ROM (CD-ROM) or a digital versatile disc (DVD)). The computer-readable recording medium may be distributed in computer systems connected via a network and may store and execute computer-readable code in a distributed manner. The medium is readable by a computer, stored in a memory, and executable by a processor.

The computer-readable storage medium may be provided in the form of a non-transitory storage medium. Here, the term 'non-transitory' merely means that the storage medium is a tangible device, and does not include a signal, but this term does not differentiate between where data is semi-permanently stored in the storage medium and where the data is temporarily stored in the storage medium. For example, the non-transitory storage medium may include a buffer in which data is temporarily stored.

In addition, a program according to embodiments disclosed herein may be provided in a computer program product. The computer program product may be traded as commodities between sellers and buyers.

The computer program product may include a software program and a computer-readable recording medium storing the software program. For example, the computer program product may include a product (e.g., a downloadable application) in the form of a software program electronically distributed through a manufacturer of the electronic device or an electronic market (e.g., Samsung Galaxy Store^{™} or Google Play Store^{™}). For electronic distribution, at least part of the software program may be stored in a storage medium or temporarily generated. In this case, the storage medium may be a storage medium of a server of the manufacturer of the vehicle 10, a server of the manufacturer of the electronic device 100, a server of the electronic market, or a relay server that temporarily stores the software program.

The computer program product may include a storage medium of the server 200 or a storage medium of another electronic device, in a system including the electronic device 100, the server 200 (see FIGS. 15 and 16), and other electronic devices. Alternatively, in a case that there is a third device (e.g., a mobile device such as a smart phone) communicating with the electronic device 100, the computer program product may include a storage medium of the third device. Alternatively, the computer program product may include a software program, which is transmitted from the electronic device 100 to the third device or transmitted from the third device to the electronic device 100.

In this case, one of the electronic device 100, another electronic device, or the third device (e.g., a mobile device such as a smart phone) may execute the computer program product to perform the method according to the disclosed embodiments. Alternatively, two or more of the electronic device 100, the other electronic device, and the third device may execute the computer program product to execute the method according to the disclosed embodiments in a distributed manner.

For example, the electronic device 100 may execute the computer program product stored in the memory 140 (see FIG. 2) to control another electronic device communicatively connected to the electronic device 100 to perform the method according to the disclosed embodiments.

As another example, the third device may execute the computer program product to control an electronic device communicatively connected to the third device to perform the method according to the disclosed embodiments.

In a case that the third device executes the computer program product, the third device may download the computer program product from the electronic device 100 and execute the downloaded computer program product. Alternatively, the third device may execute the computer program product provided in a pre-loaded state to perform the method according to the disclosed embodiments.

Although the embodiments have been described with the limited embodiments and the drawings, various modifications and changes may be made by those of skill in the art from the above description. For example, suitable results may be obtained even when the described techniques are performed in a different order, or when components in a described electronic device, architecture, device, or circuit are coupled or combined in a different manner, or replaced or supplemented by other components or their equivalents.

## Claims

1. An electronic device (100) mounted on a vehicle (10), the electronic device (100) comprising:
a sensor (110) comprising a temperature sensor (112);
a communication module (120) comprising at least one of a millimeter-wave communication module (122) and a Vehicle-to-Everything (V2X) communication module (124);
an active cooler (160) comprising a thermoelectric cooler (TEC) (162) and a fan (164) and configured to lower a temperature of the communication module (120) according to applied power;
a voltage regulator (150) configured to adjust operating power applied to the active cooler (160);
a memory (140) storing at least one instruction; and
at least one processor (130) configured to execute the at least one instruction,
wherein the at least one processor (130) is further configured to obtain an outside air temperature around the vehicle (10), which is measured by the temperature sensor (112), obtain operating state information about the communication module (120), the operating state information comprising information about at least one of a power consumption and a temperature of the communication module (120), determine, based on the outside air temperature around the vehicle (10) and the operating state information about the communication module (120), a cooling level for lowering the temperature of the communication module (120) to a target temperature, and control the voltage regulator (150) to apply a variable voltage to the active cooler (160) based on the determined cooling level.

2. The electronic device (100) of claim 1, wherein the at least one processor (130) is further configured to detect an event triggered by at least one of a change in an operating state of the communication module (120), a change in a driving state of the vehicle, and a change in the outside air temperature, and determine, based on the detected event, the cooling level for lowering the temperature of the communication module (120).

3. The electronic device (100) of claim 2, wherein the at least one processor (130) is further configured to detect an event triggered by at least one of turn-on of an integrated circuit included in the communication module (120), a change in a transmission output value of the communication module (120), and a change in a number of operating antenna arrays in the millimeter-wave communication module, and adjust the cooling level based on the detected event.

4. The electronic device (100) of claim 2, wherein the at least one processor (130) is further configured to obtain, from a speed sensor (114), information about a driving speed of the vehicle (10), detect the outside air temperature that has changed according to the driving speed of the vehicle, and adjust the cooling level based on the changed outside air temperature.

5. The electronic device (100) of any one of claims 1 to 4, wherein a look-up table (LUT) (142) comprising information about a correspondence relationship between cooling temperature values for the communication module (120) and voltage setting values for a variable voltage to be applied to the communication module (120) is stored in a storage in the memory (140), and
the at least one processor (130) is further configured to obtain, by loading the LUT (142) from the memory (140), a voltage setting value corresponding to a cooling temperature value for lowering the temperature of the communication module (120) to the target temperature, and control the voltage regulator (150) to apply the obtained voltage setting value to the active cooler (160).

6. The electronic device (100) of claim 5, wherein the LUT (142) comprises a plurality of tables for a plurality of different outside air temperatures, respectively, each of the plurality of tables comprising a correspondence relationship between the cooling temperature values and voltage setting values, and
the at least one processor (130) is further configured to select, from among the plurality of tables, a table corresponding to the outside air temperature around the vehicle, and obtain a voltage setting value for cooling the communication module (120) by the cooling temperature value by loading the selected table from the memory (140).

7. The electronic device (100) of claim 5 or claim 6, wherein the at least one processor (130) is further configured to calibrate the voltage setting values included in the LUT (142) by monitoring a relationship between the variable voltage applied to the communication module (120) and the cooling temperature value for the communication module (120) according to the outside air temperature around the vehicle, upon delivery of the vehicle or when operation of the vehicle is stopped.

8. An operating method of an electronic device (100) mounted on a vehicle (10), the operating method comprising:
obtaining an outside air temperature around the vehicle (10), which is measured by a temperature sensor (112) (S410),
obtaining operating state information about a communication module (120), the operating state information comprising information about at least one of a power consumption and a temperature of at least one of a millimeter-wave (mmWave) communication module (122) and a Vehicle-to-Everything (V2X) communication module (124) (S420);
determining, based on the outside air temperature and the operating state information about the communication module (120), a cooling level for lowering a temperature of the communication module (120) to a target temperature (S430); and
applying, based on the determined cooling level, a variable voltage to an active cooler (160) (S440).

9. The operating method of claim 8, further comprising detecting an event triggered by at least one of a change in an operating state of the communication module (120), a change in a driving state of the vehicle, and a change in the outside air temperature,
Wherein the determining of the cooling level (S430) comprises determining, based on the detected event, the cooling level for lowering the temperature of the communication module (120).

10. The operating method of claim 9, wherein the detecting of the event comprises detecting an event triggered by at least one of turn-on of an integrated circuit included in the communication module (120), a change in a transmission output value of the communication module (120), and a change in a number of operating antenna arrays in the millimeter-wave communication module (S610), and
the determining of the cooling level (S430) comprises adjusting the cooling level based on the detected event (S620).

11. The operating method of claim 9, further comprising obtaining, from a speed sensor, information about a driving speed of the vehicle (S710), wherein the detecting of the event comprises detecting the outside air temperature that has changed according to the driving speed of the vehicle (S720), and
the determining of the cooling level (S430) comprises adjusting the cooling level based on the changed outside air temperature (S730).

12. The operating method of any one of claims 8 to 11, wherein a look-up table (LUT) (142) comprising information about a correspondence relationship between cooling temperature values for the communication module (120) and voltage setting values for a variable voltage to be applied to the communication module (120) is stored in a storage in the memory (140), and
the applying of the variable voltage to the active cooler (160) (S440) comprises:
obtaining, by loading the LUT (142) from the memory (140), a voltage setting value corresponding to a cooling temperature value for lowering the temperature of the communication module (120) to the target temperature; and
applying the obtained voltage setting value to the active cooler (160).

13. The operating method of claim 12, wherein the LUT (142) comprises a plurality of tables for a plurality of different outside air temperatures, respectively, each of the plurality of tables comprising a correspondence relationship between the cooling temperature values and voltage setting values, and
the obtaining of the voltage setting value corresponding to the cooling temperature value comprises:
selecting, from among the plurality of tables, a table corresponding to the outside air temperature around the vehicle (S1110); and
obtain the voltage setting value for cooling the communication module (120) by the cooling temperature value by loading the selected table (S1120).

14. The operating method of claim 12 or 13, further comprising calibrating the voltage setting values included in the LUT (142) by monitoring a relationship between the variable voltage applied to the communication module (120) and the cooling temperature value for the communication module (120) according to the outside air temperature around the vehicle, upon delivery of the vehicle or when operation of the vehicle is stopped.

15. A computer program product comprising a computer-readable storage medium,
wherein the storage medium stores instructions readable by an electronic device (100), the instructions causing the electronic device (100) to perform:
obtaining an outside air temperature around a vehicle (10), which is measured by a temperature sensor (112);
obtaining operating state information about a communication module (120), the operating state information comprising information about at least one of a power consumption and a temperature of at least one of a millimeter-wave (mmWave) communication module (122) and a Vehicle-to-Everything (V2X) communication module (124);
determining, based on the outside air temperature and the operating state information about the communication module (120), a cooling level for lowering a temperature of the communication module (120) to a target temperature; and
applying, based on the determined cooling level, a variable voltage to an active cooler (160).
